(19) Europäisches Patentamt
European Patent Office
Office européen des brevets

(11) **EP 1 151 344 B1**

(12) **EUROPÄISCHE PATENTSCHRIFT**

(45) Veröffentlichungstag und Bekanntmachung des Hinweises auf die Patenterteilung:
**16.09.2009 Patentblatt 2009/38**

(51) Int Cl.:
*G02B 27/09* (2006.01)    *H01S 5/40* (2006.01)
*H01S 5/42* (2006.01)

(21) Anmeldenummer: **00969444.9**

(22) Anmeldetag: **06.10.2000**

(86) Internationale Anmeldenummer:
**PCT/EP2000/009820**

(87) Internationale Veröffentlichungsnummer:
**WO 2001/025835 (12.04.2001 Gazette 2001/15)**

(54) **LASERSTRAHLUNGSQUELLE ZUM ERZEUGEN EINES KOHÄRENTEN GESAMTLASERSTRAHLUNGSFELDES**

LASER RADIATION SOURCE FOR PRODUCING A COHERENT AND ENTIRE LASER RADIATION FIELD

SOURCE DE RAYONNEMENT LASER POUR PRODUIRE UN CHAMP DE RAYONNEMENT LASER GLOBAL COHERENT

(84) Benannte Vertragsstaaten:
**DE FR GB IT**

(30) Priorität: **07.10.1999 DE 19948353**

(43) Veröffentlichungstag der Anmeldung:
**07.11.2001 Patentblatt 2001/45**

(73) Patentinhaber:
• **Deutsches Zentrum für Luft- und Raumfahrt e.V.**
**51147 Köln (DE)**
• **OSRAM Opto Semiconductors GmbH**
**93055 Regensburg (DE)**
• **UNIVERSITÄT STUTTGART INSTITUT FÜR STRAHLWERKZEUGE**
**70569 Stuttgart (DE)**

(72) Erfinder:
• **BISSINGER, Norbert**
**73035 Göppingen (DE)**
• **BRAUCH, Uwe**
**70565 Stuttgart (DE)**
• **HERGENHAN, Guido**
**70374 Stuttgart (DE)**
• **OPOWER, Hans**
**82152 Krailling (DE)**
• **SCHOLL, Marcus**
**52223 Stolberg (DE)**
• **LÜCKE, Bernd**
**70176 Stuttgart (DE)**
• **SPÄTH, Werner**
**83607 Holzkirchen (DE)**

(74) Vertreter: **Hoeger, Stellrecht & Partner Patentanwälte**
**Uhlandstrasse 14c**
**70182 Stuttgart (DE)**

(56) Entgegenhaltungen:
| | |
|---|---|
| **EP-A- 0 661 785** | **DE-A- 19 811 032** |
| **DE-A- 19 823 883** | **US-A- 4 649 351** |
| **US-A- 4 933 649** | **US-A- 5 363 233** |
| **US-A- 5 814 841** | |

• **BARTELT-BERGER L ET AL: "POWER-SCALABLE SYSTEM OF PHASE-LOCKED SINGLE-MODE DIODE LASERS" APPLIED OPTICS,OPTICAL SOCIETY OF AMERICA, WASHINGTON,US, Bd. 38, Nr. 27, 20. September 1999 (1999-09-20), Seiten 5752-5760, XP000860562 ISSN: 0003-6935**
• **HOHIMER J P ET AL: "INTEGRATED INJECTION-LOCKED HIGH-POWER CW DIODE LASER ARRAYS" APPLIED PHYSICS LETTERS,US, AMERICAN INSTITUTE OF PHYSICS. NEW YORK, Bd. 55, Nr. 6, 7. August 1989 (1989-08-07), Seiten 531-533, XP000080868 ISSN: 0003-6951**

- HERGENHAN G ET AL: "Fast coherence switching of an injection-locked vertical-cavity laser array" CONFERENCE ON LASERS AND ELECTRO-OPTICS (CLEO 2000). TECHNICAL DIGEST. POSTCONFERENCE EDITION. TOPS VOL.39 (IEEE CAT. NO.00CH37088), CONFERENCE ON LASERS AND ELECTRO-OPTICS (CLEO 2000). TECHNICAL DIGEST. POSTCONFERENCE EDITION. TOPS VOL.39, SAN FRANC, Seiten 100-101, XP002158972 2000, Salem, MA, USA, Opt. Soc. America, USA ISBN: 1-55752-634-6
- EHBETS P ET AL: "Beam shaping of high-power laser diode arrays by continuous surface-relief elements" JOURNAL OF MODERN OPTICS, APRIL 1993, UK, Bd. 40, Nr. 4, Seiten 637-645, XP000980677 ISSN: 0950-0340 in der Anmeldung erwähnt
- PATENT ABSTRACTS OF JAPAN vol. 012, no. 425 (E-681), 10. November 1988 (1988-11-10) & JP 63 164287 A (MATSUSHITA ELECTRIC IND CO LTD), 7. Juli 1988 (1988-07-07)

**Beschreibung**

Die Erfindung betrifft eine Laserstrahlungsquelle umfassend eine Anordnung von N einzelnen Slave-Laserdioden in einer vorgegebenen Fläche, eine Slave-Stromversorgung für die Slave-Laserdioden, eine Master-Laserdiode zur Erzeugung einer Master-Laserstrahlung, eine Master-Stromversorgung für die Master-Laserdiode, eine Kopplungsoptik, mit welcher die Master-Laserstrahlung in die einzelnen Slave-Laserdioden einkoppelbar ist, um diese bei der Frequenz der Master-Laserdiode phasenstarr zu betreiben, und eine Transformationsoptik, welche aus der Slave-Laserstrahlung der einzelnen Slave-Laserdioden ein kohärentes Gesamtlaserstrahlungsfeld mit im wesentlichen definierten, vorzugsweise ebenen Wellenfronten bildet.

Derartige Laserstrahlungsquellen sind aus dem Stand der Technik bekannt (siehe z.B. Lars Bartelt-Berger et al., Applied Optics, 20, September 1999, Bd. 38, Nr. 27, Seiten 5752-5760).

Bei diesen besteht jedoch das Problem, daß der stabile Betrieb der einzelnen Slave-Laserdioden äußerst aufwendig ist.

Der Erfindung liegt daher die Aufgabe zugrunde, eine Laserstrahlungsquelle der gattungsgemäßen Art derart zu verbessern, daß die Slave-Stromversorgung für jede Slave-Laserdiode ein eigenes Stromversorgungsnetzwerk aufweist, daß jedes der Stromversorgungsnetzwerke hinsichtlich des der jeweiligen Slave-Laserdiode während einer bestimmten Betriebsdauer zugeführten Stroms zur Abstimmung der Slave-Laserdioden relativ zueinander abgleichbar ist und daß die Stromversorgungsnetzwerke parallelgeschaltet und durch eine gemeinsame Quelle gespeist sind.

Die Lösung der Aufgabe wird durch die Merkmale des Anspruchs 1 gelöst. Weitere Ausgestaltungen der Erfindung werden in den abhängigen Ansprüchen 2-36 definiert.

Der Vorteil der erfindungsgemäßen Lösung ist darin zu sehen, daß durch die Abgleichbarkeit der Stromversorgungsnetzwerke die Möglichkeit besteht, die Slave-Laserdioden relativ zueinander abzustimmen und somit in Relation zueinander stabil zu betreiben.

Gleichzeitig wird durch die Tatsache, daß die Stromversorgungsnetzwerke parallelgeschaltet und durch eine gemeinsame Quelle gespeist sind, die relative Stabilität des Betriebs der einzelnen Slave-Laserdioden weiter verbessert, da Schwankungen in der Versorgung durch die gemeinsame Quelle in gleichem Maße alle Slave-Laserdioden betreffen, so daß die relative Abstimmung der Slave-Laserdioden zueinander nicht beeinträchtigt wird.

Somit wird durch die erfindungsgemäße Lösung eine einfach realisierbare Möglichkeit geschaffen, eine beliebig große Zahl von Slave-Laserdioden relativ zueinander abzustimmen und in dieser Abstimmung relativ zueinander über eine bestimmte Betriebsdauer stabil zu betreiben.

Im Sinne der erfindungsgemäßen Lösung ist es dabei möglich, die Abstimmung nur für eine bestimmte Betriebsdauer vorzunehmen. Beispielsweise wäre es denkbar, vor jeder Inbetriebnahme die Slave-Laserdioden relativ zueinander abzustimmen, mit einer später noch im einzelnen vorzusehenden Vorgehensweise.

Noch besser ist es jedoch, wenn die Slave-Laserdioden relativ zueinander nur in gewissen Zeitabständen, d. h. längeren Betriebsperioden, nachgestimmt werden müssen, so daß das aufwendige Abstimmen der Slave-Laserdioden relativ zueinander bei jeder Inbetriebnahme damit entfallen kann.

Besonders vorteilhaft ist es jedoch, wenn die Slave-Laserdioden relativ zueinander dadurch abgestimmt werden, daß jedes der Stromversorgungsnetzwerke einmalig abgleichbar ist.

Eine derartige einmalige Abgleichbarkeit eines Stromversorgungsnetzwerks ist aus der Schaltungstechnik durch vielfältige Lösungen bekannt. Beispielsweise ist es bekannt, komplexe Schaltungen einmalig zu trimmen, so daß diese nachfolgend entsprechend der einmaligen Trimmung arbeiten.

Prinzipiell ist es denkbar, die Stromversorgungsnetzwerke beliebig komplex auszuführen, da mit modernem Aufbau von elektronischen Schaltungen auch komplexe Schaltungsnetzwerke in großer Zahl und einfach hergestellt werden können. Beispielsweise wäre es denkbar, die Stromversorgungsnetzwerke mit einstellbaren Stromstabilisierungsschaltungen unter Verwendung von Halbleiterbauteilen auszuführen.

Besonders günstig ist es jedoch, wenn jedes der Stromversorgungsnetzwerke ein Widerstandsnetzwerk ist, da ein Widerstandsnetzwerk einerseits kostengünstig aufzubauen ist und andererseits in sehr einfacher Weise abgleichbar ist.

Eine besonders günstige Lösung sieht dabei vor, daß jedes der Stromversorgungsnetzwerke einen durch Querschnittsveränderung abgleichbaren Widerstand aufweist.

Prinzipiell wäre es denkbar, das Widerstandsnetzwerk auch dahingehend auszubilden, daß der abgleichbare Widerstand eine parasitäre Stromsenke darstellt, welche parallel zur jeweiligen Slave-Laserdiode geschaltet ist.

Besonders günstig ist es jedoch hinsichtlich des Leistungsverbrauchs, wenn jedes der Stromversorgungsnetzwerke einen mit der jeweiligen Slave-Laserdiode in Reihe geschalteten abgleichbaren Widerstand aufweist, da damit in direkter Weise der Strom durch die Slave-Laserdiode beeinflußbar ist und außerdem der Stromverbrauch minimiert werden kann.

Die Stromversorgungsnetzwerke könnten prinzipiell durch eine beliebige gemeinsame Quelle gespeist sein. Eine besonders günstige Lösung sieht vor, daß alle Stromversorgungsnetzwerke durch eine gemeinsame Spannungsquelle gespeist sind, so daß sich insbesondere die Stromversorgungsnetzwerke als einfache Widerstandsnetzwerke ausbilden lassen, mit denen in einfacher Weise durch Variation des Widerstands der Strom festlegbar ist.

Vorzugsweise ist die gemeinsame Spannungsquelle eine spannungsstabilisierte Spannungsquelle, so daß Schwankungen der Spannung weitgehend vermieden werden, und somit eine zusätzliche Stabilisierung der Abstimmung der Slave-Laserdioden relativ zueinander erreichbar ist.

Prinzipiell wäre es denkbar, die Stromversorgung der Master-Laserdiode entsprechend der Slave-Stromversorgung auszubilden und beispielsweise über die gemeinsame Quelle der Slave-Stromversorgung ebenfalls zu versorgen.

Besonders günstig ist es jedoch, im Hinblick auf die Freiheitsgrade der Abstimmung der Master-Laserdiode relativ zu den Slave-Laserdioden, wenn die Slave-Stromversorgung unabhängig von der Master-Stromversorgung arbeitet, so daß ein völlig selbständiger Betrieb der Master-Laserdiode möglich ist.

Besonders zweckmäßig ist es dabei, wenn die Master-Stromversorgung hinsichtlich des Stroms durch die Master-Laserdiode steuerbar ist und somit beispielsweise eine gesteuerte Modulation der Master-Laserstrahlung realisierbar ist.

Beispielsweise wäre durch eine gesteuerte Modulation der Master-Laserdiode auch die Möglichkeit gegeben, die Intensität des Gesamtlaserstrahlungsfeldes zu modulieren, nämlich dann, wenn die Modulation der Master-Laserdiode so weit getrieben wird, daß diese die Slave-Laserdioden nicht mehr gekoppelt betreibt.

Hierdurch ist es beispielsweise in einfacher Weise und mit geringer Variation des Stromes möglich, eine große Modulationstiefe in der Intensität des Gesamtlaserstrahlungsfeldes zu erhalten, und somit auch mit geringem Strom eine große optische Leistung zu schalten, wobei ein schnelles Schalten der großen optischen Leistung aufgrund der kurzen Ansprechzeiten in der Wechselwirkung zwischen der Master-Laserstrahlung und den Slave-Laserdioden möglich ist.

Um den Betrieb der Slave-Laserdioden relativ zueinander möglichst stabil gestalten zu können, ist vorzugsweise vorgesehen, daß alle Slave-Laserdioden auf einem gemeinsamen Träger angeordnet sind.

Besonders günstig ist es für die Herstellung der Slave-Laserdioden, wenn der gemeinsame Träger für die Slave-Laserdioden ein Substrat ist, auf dem die Slave-Laserdioden bei ihrer Herstellung aufgebaut sind.

Prinzipiell wäre es denkbar, jede einzelne Slave-Laserdiode zur Stromversorgung mit einer elektrischen Leitung zu kontaktieren, ähnlich dem aus der Halbleitertechnik bekannten Vorgang des Bondens von Halbleitern. Besonders günstig für die Realisierung der Stromversorgung der Slave-Laserdioden ist es jedoch, wenn die Stromversorgung der Slave-Laserdioden durch auf dem Träger verlaufende Leiterbahnen erfolgt.

Beispielsweise wäre es dabei denkbar, bei einer zweidimensionalen Anordnung von Slave-Laserdioden auf einer Seite des Substrats die Slave-Laserdioden einer Reihe mit einer gemeinsamen Leiterbahn zu verbinden und auf der gegenüberliegenden Seite des Substrats quer dazu verlaufende Reihen von Slave-Laserdioden mit einer gemeinsamen quer zur ersten Leiterbahn verlaufenden Leiterbahn zu verbinden, so daß eine sogenannte Matrixansteuerung der Slave-Laserdioden möglich wäre.

Besonders einfach ist es jedoch, wenn alle Slave-Laserdioden einer Anordnung auf einer Seite mit einer gemeinsamen Leiterbahn verbunden sind und auf der gegenüberliegenden Seite durch das jeweilige Stromversorgungsnetzwerk gespeist sind.

Vorzugsweise ist dabei aus Gründen einer möglichst einfachen Herstellbarkeit vorgesehen, daß die Stromversorgungsnetzwerke für die Slave-Laserdioden auf dem Träger angeordnet sind.

Beispielsweise ließe sich dabei vorsehen, die Stromversorgungsnetzwerke neben der Anordnung der Slave-Laserdioden zu positionieren und jedes der Stromversorgungsnetzwerke durch eine geeignete Leiterbahn mit der entsprechenden Slave-Laserdiode zu verbinden.

Noch vorteilhafter ist es jedoch, wenn jeder Slave-Laserdiode ein auf dem Träger im Bereich der jeweiligen Slave-Laserdiode angeordnetes Stromversorgungsnetzwerk zugeordnet ist, so daß beispielsweise das Stromversorgungsnetzwerk in der unmittelbaren Umgebung der jeweiligen Slave-Laserdiode angeordnet ist und damit wiederum sämtliche Stromversorgungsnetzwerke durch alle Stromversorgungsnetzwerke miteinander verbindende gemeinsame Leiterbahnen über die gemeinsame Quelle versorgt werden können.

Besonders günstig ist es dabei, wenn das Stromversorgungsnetzwerk auf dem Träger angeordnete, hinsichtlich ihres Widerstandes abgleichbare Leiterabschnitte aufweist, da diese platzsparend angeordnet werden können, so daß die Möglichkeit besteht, das jeweilige Stromversorgungsnetzwerk im Bereich der jeweiligen Slave-Laserdiode vorzusehen und andererseits in einfacher Weise abgeglichen werden können.

Dabei wäre es beispielsweise denkbar, zum Abgleich eine Materialvariation vorzusehen. Besonders günstig ist es jedoch, wenn die Leiterabschnitte durch Variation eines Querschnitts derselben abgleichbar sind, wobei beispielsweise auch ein Materialauftrag zur Querschnittsvariation denkbar ist.

Unter einer Variation des Querschnitts eines Leiterabschnitts zum Abgleichen des Widerstands ist nicht nur eine Verringerung des Querschnitts zu verstehen, sondern auch eine Vergrößerung des Querschnitts sowie die Verbindung zweier zunächst unterbrochener Abschnitte einer Leiterbahn zur Erniedrigung des Widerstands.

Eine besonders günstige Technologie sieht vor, daß jedes der Stromversorgungsnetzwerke durch Lasertrimmen abgleichbar ist, da damit in besonders einfacher und kostengünstiger Weise ein Abgleich der einzelnen Stromversorgungsnetzwerke relativ zueinander möglich ist.

Hinsichtlich der Abstimmung der Slave-Laserdioden relativ zueinander wurden bislang keine näheren Angaben gemacht. Ein entscheidendes Kriterium ist die Möglichkeit, die Slave-Laserdioden so abzustimmen, daß die Slave-Laserstrahlungen sich kohärent zum Gesamtlaserstrahlungsfeld überlagern.

Besonders günstig ist es dabei, wenn jede Slave-Laserdiode so ausgebildet ist, daß durch Einstellung des Stroms eine Resonatorfrequenz der Slave-Laserdiode einstellbar ist, um den Arbeitsbereich der Slave-Laserdiode so zu legen, daß diese auf der Frequenz der Master-Laserstrahlung arbeitet.

Darüber hinaus ist ein kritischer Parameter bei der Einstellung der Slave-Laserdioden relativ zueinander die Phasenlage der Slave-Laserstrahlung.

Aus diesem Grund ist es besonders günstig, wenn eine Phasenlage der Slave-Laserstrahlung jeder Slave-Laserdiode relativ zur Phase der Master-Laserstrahlung durch Einstellung des Stroms einstellbar ist.

Mit dieser Lösung besteht der große Vorteil, daß die Slave-Laserdioden durch die Master-Laserdiode nicht nur auf derselben Frequenz und phasenstarr relativ zueinander betrieben werden, sondern auch noch die Möglichkeit, die einzelnen Slave-Laserdioden zusätzlich zum phasenstarren Betrieb noch in ihrer Phasenrelation zur Master-Laserstrahlung einzustellen und somit beispielsweise durch unterschiedliche optische Weglängen bedingte Phasenunterschiede auszugleichen, so daß die Slave-Laserstrahlungen sich tatsächlich phasengleich zu dem kohärenten Gesamtlaserstrahlungsfeld überlagern.

Hinsichtlich der Anordnung der einzelnen Slave-Laserdioden wurden bislang keine näheren Angaben gemacht. So wäre es beispielsweise denkbar, die Slave-Laserdioden beliebig, auch beispielsweise in einer Reihe, anzuordnen.

Besonders vorteilhaft ist es jedoch, wenn die Slave-Laserdioden in einer zweidimensionalen Anordnung angeordnet sind.

Eine derartige zweidimensionale Anordnung könnte nach wie vor ein unregelmäßiges Muster sein. Besonders günstig ist es jedoch, wenn die Slave-Laserdioden in der zweidimensionalen Anordnung in einem regelmäßigen Muster angeordnet sind, um insbesondere auch die Transformationsoptik entsprechend ausbilden und abstimmen zu können.

Eine derartige zweidimensionale Anordnung könnte dergestalt ausgebildet sein, daß sie nach wie vor eine langgestreckte Form aufweist.

Um die optischen Komponenten besonders vorteilhaft ausnützen zu können und insbesondere auch eine möglichst günstige räumliche Intensitätsverteilung im kohärenten Gesamtlaserstrahlungsfeld zu erhalten, ist vorzugsweise vorgesehen, daß die zweidimensionale Anordnung in jeder Dimension eine Erstreckung von ungefähr derselben Größenordnung aufweist.

Vorzugsweise ist die zweidimensionale Anordnung so, daß sie in jeder Dimension im wesentlichen dieselbe Größenordnung aufweist.

Hinsichtlich der Anordnung der Slave-Laserdioden und der Master-Laserdiode relativ zueinander wurden im Zusammenhang mit der bisherigen Erläuterung der einzelnen Ausführungsformen der Erfindung keine näheren Angaben gemacht. So wäre es beispielsweise denkbar, die Master-Laserdiode völlig separat von den Slave-Laserdioden vorzusehen, da rein theoretisch die optische Kopplung der Master-Laserdiode mit den Slave-Laserdioden ausreicht.

Um jedoch die Master-Laserdiode hinsichtlich der Umgebungsbedingungen, insbesondere der Temperaturbedingungen, ähnlich wie die Slave-Laserdioden betreiben zu können, und um auch die Master-Laserdiode hinsichtlich ihrer Gesamtspezifikationen möglichst ähnlich zu den Slave-Laserdioden herstellen zu können, ist vorzugsweise vorgesehen, daß die Slave-Laserdioden und die Master-Laserdiode auf demselben Träger sitzen. Noch vorteilhafter ist es, wenn die Slave-Laserdioden und die Master-Laserdiode auf demselben Substrat sitzen.

Eine besonders günstige Laserdiode sieht vor, daß eine der Laserdioden einer zusammenhängenden Anordnung von Laserdioden die Master-Laserdiode darstellt und die anderen Laserdioden als Slave-Laserdioden arbeiten. D. h., daß zunächst eine Anordnung von möglichst identischen Laserdioden hergestellt wird, eine der Laserdioden als Master-Laserdiode ausgewählt wird und die übrigen Laserdioden dann als Slave-Laserdioden betrieben werden.

Hinsichtlich der Ausbildung der Laserdioden selbst wurden im Zusammenhang mit der bisherigen Erläuterung der erfindungsgemäßen Lösung keine spezifischen Angaben gemacht. So wäre es prinzipiell denkbar, als Laserdioden sogenannte Kantenemitter einzusetzen.

Da sich derartige Kantenemitter vorzugsweise jedoch nur gemeinsam als eindimensionale Anordnungen kostengünstig herstellen lassen, und somit zweidimensionale Anordnungen von Kantenemittern einen aufwendigeren Herstellungsvorgang bedingen würden, ist vorzugsweise vorgesehen, daß die Laserdioden als Vertikalemitter auf einem einzigen zusammenhängenden Substrat angeordnet sind.

Derartige Vertikalemitter oder auch VCSEL genannt, lassen sich in besonders einfacher Weise auf einem gemeinsamen Substrat durch bekannte Herstellungsprozesse aufbauen, wobei die Struktur beispielsweise durch Implantation, durch Mesa-Ätzung oder durch Mesa-Ätzung und Oxidation der Stromblende hergestellt wird.

Ferner haben derartige Vertikalemitter den Vorteil, daß sie sich in einfacher Weise kontaktieren lassen, da über das Substrat eine gemeinsame Kontaktierung aller Vertikalemitter erfolgen kann, und im übrigen läßt sich jeder einzelne Vertikalemitter auf seiner Austrittsseite für die Laserstrahlung ebenfalls in einfacher Weise selektiv kontaktieren.

Eine derartige zweidimensionale Anordnung von Vertikalemittern schafft somit die Möglichkeit, beispielsweise in den Bereichen zwischen den Vertikalemittern Leiterbahnen für die Stromversorgung und jeweils jedem Vertikalemitter zugeordnet das entsprechende Stromversorgungsnetzwerk, beispielsweise in Form von abgleichbaren Widerständen, vorzusehen.

Im Zusammenhang mit der bisherigen Erläuterung der einzelnen Ausführungsbeispiele wurde nicht näher darauf eingegangen, wie die Transformationsoptik ausgebildet sein soll.

Die Transformationsoptik kann grundsätzlich beliebig ausgebildet sein, solange mit dieser aus den Slave-Laserstrahlungen das Gesamtlaserstrahlungsfeld gebildet werden kann.

Beispielsweise ist es denkbar, daß die Transformationsoptik ein Mikrolinsenarray umfaßt. Dabei ist es vorzugsweise im einfachsten Fall ausreichend, wenn die Transformationsoptik ausschließlich ein Mikrolinsenarray umfaßt.

Die Transformationsoptik kann darüber hinaus aber auch als komplexe Optik ausgebildet sein, in welche beispielsweise ebenfalls ein Mikrolinsenarray integriert sein kann.

Eine vorteilhafte Lösung einer Transformationsoptik sieht vor, daß diese eine Phasenplatte aufweist, welche die Phase der Slave-Laserstrahlung derart ändert, daß in einer weiteren Ebene eine definierte Intensitätsverteilung entsteht und daß die Transformationsoptik in der weiteren Ebene eine auf die erste Phasenplatte abgestimmte Phasenkorrekturplatte umfaßt, welche in dem austretenden Gesamtlaserstrahlungsfeld zu einer definierten Wellenfront führt.

Eine derartige definierte Wellenfront kann grundsätzlich unterschiedlichste Formen haben, besonders vorteilhaft ist es, wenn die definierte Wellenfront eine im wesentlichen ebene Wellenfront ist.

Eine besonders zweckmäßige Lösung sieht vor, daß die Transformationsoptik eine Phasenplatte aufweist, welcher jeder Slave-Laserstrahlung einer Slave-Laserdiode eine andere Phase gibt und daß die Transformationsoptik eine Fourieroptik umfaßt, in deren Fourierebene eine auf die erste Phasenplatte abgestimmte Phasenkorrekturplatte angeordnet ist, welche den Slave-Laserstrahlungen mit unterschiedlicher Phase wieder dieselbe Phase verleiht und somit in dem austretenden Gesamtlaserstrahlungsfeld zu der definierten, ebenen Wellenfront führt.

Mit einer derartigen Transformationsoptik läßt sich einerseits eine im wesentlichen gleichförmige räumliche Intensitätsverteilung im Gesamtlaserstrahlungsfeld bei ebenen Wellenfronten schaffen, wobei die im wesentlichen gleichförmige Intensitätsverteilung beispielsweise eine Intensitätsverteilung ähnlich einem Gaussprofil oder einem sogenannten flat-top-Profil sein kann.

Prinzipiell kann die Phasenplatte so ausgebildet sein, daß sie den verschiedenen Slave-Laserstrahlungen eine statistische Phasenverschiebung relativ zueinander verleiht.

Besonders günstig für das Erreichen einer möglichst hohen Intensität bei möglichst gleichmäßiger räumlicher Intensitätsverteilung ist es jedoch, wenn die Phasenplatte eine durch einen Algorithmus festgelegte Phasenverschiebung zwischen der Slave-Laserstrahlung verschiedener Slave-Laserdioden bewirkt.

Ein besonders vorteilhafter Algorithmus sieht dabei vor, daß die Phasenplatte eine ausgehend von einem Mittelpunkt nach allen Richtungen in gleicher Weise variierende Phasenlage bewirkt.

Ein besonders günstiges Ausführungsbeispiel sieht vor, daß die Variation der Phasenlage in allen Richtungen entsprechend einer monoton verlaufenden analytischen Funktion erfolgt.

Hinsichtlich des Zusammenhangs zwischen der Kopplungsoptik und der Transformationsoptik wurden bislang keine näheren Angaben gemacht. So wäre es beispielsweise denkbar, die Kopplungsoptik völlig unabhängig von der Transformationsoptik auszubilden und somit die Kopplung völlig unabhängig von der Transformationsoptik zu gestalten.

Eine besonders günstige Lösung sieht vor, daß die Kopplungsoptik die Master-Laserstrahlung über die Transformationsoptik in die Slave-Laserdioden einkoppelt. Dadurch ist die Möglichkeit geschaffen, in einfacher und effizienter Weise die Master-Laserstrahlung in die einzelnen Slave-Laserdioden einzukoppeln.

Vorzugsweise ist dabei vorgesehen, daß die Master-Laserstrahlung sowohl die Phasenkorrekturplatte als auch die Phasenplatte durchsetzt.

Hinsichtlich der Realisierung der Transformationsoptik wäre es prinzipiell denkbar, diese in bekannter Weise in einzelnen optischen Komponenten, beispielsweise Linsen und Phasenplatten, auszuführen.

Eine besonders günstige Lösung für eine kommerzielle Realisierung sieht vor, daß die Transformationsoptik in einem zusammenhängenden Block integriert ist, da ein derartiger zusammenhängender Block insbesondere Justage-unempfindlich ist und auch in großen Stückzahlen einfach herstellbar ist.

Vorzugsweise ist dabei vorgesehen, daß die Elemente der Transformationsoptik als Elemente der diffraktiven Optik ausgebildet sind, d. h. also sowohl die Linsen als auch die Phasenplatten Elemente diffraktiver Optik sind, die sich beispielsweise durch Ätzverfahren in den jeweiligen Oberflächen des zusammenhängenden Blocks realisieren lassen.

Besonders günstig ist es dabei, wenn auch die Kopplungsoptik in den zusammenhängenden Block integriert ist.

Darüber hinaus wird die eingangs genannte Aufgabe bei einem Verfahren zum Betreiben einer Laserstrahlungsquelle, umfassend eine Anordnung von N einzelnen Slave-Laserdioden, eine Master-Laserdiode zur Erzeugung einer Master-Laserstrahlung, eine Kopplungsoptik, mit welcher die Master-Laserstrahlung in die einzelnen Slave-Laserdioden eingekoppelt wird, um diese bei der Frequenz der Master-Laserdiode phasenstarr zu betreiben, und eine Transformationsoptik, mit welcher aus der Slave-Laserstrahlung der einzelnen Slave-Laserdioden ein kohärentes Gesamtlaserstrahlungsfeld mit im wesentlichen definierten Wellenfronten gebildet wird, erfindungsgemäß dadurch gelöst, daß der jeder einzelnen Slave-Laserdiode während einer bestimmten Betriebsdauer zugeführte Strom zur Abstimmung der Slave-Laserdioden relativ zueinander einzeln so abgeglichen wird, daß sich die Slave-Laserstrahlungen im Gesamtlaserstrahlungsfeld kohärent mit gleicher Phase überlagern.

Der Vorteil des Verfahrens ist darin zu sehen, daß mit diesem erstmalig eine einfache Möglichkeit der Abstimmung der Slave-Laserdioden relativ zueinander zur Verfügung gestellt wird, um die Slave-Laserstrahlungen im Gesamtlaserstrahlungsfeld kohärent überlagern zu können, da lediglich ein Abgleich des jeder einzelnen Slave-Laserdiode zugeführten Stroms ausreichend ist, um die kohärente Überlagerung der Slave-Laserstrahlungen zum Gesamtlaserstrahlungsfeld zu erreichen.

Unter dem Begriff "Abgleich" ist dabei eine Abstimmung für jeweils festzulegende Betriebsdauern zu verstehen. Unter Betriebsdauer ist beispielsweise die Dauer des jeweiligen Betriebs der Slave-Laserdioden von einem einmaligen Einschalten bis zu einem Abschalten zu verstehen. Es ist aber auch unter einer Betriebsdauer eine längere Betriebsdauer, beispielsweise von Tagen, Monaten oder Jahren zu verstehen, für welche ein einmaliger Abgleich ausreichend ist.

Besonders vorteilhaft ist es, wenn der Strom für jede einzelne Slave-Laserdiode einmalig abgeglichen wird, so daß durch einen einmaligen Abgleich sämtliche Slave-Laserdioden relativ zueinander während ihrer ganzen Lebensdauer abgestimmt sind.

Prinzipiell wäre es im Rahmen der erfindungsgemäßen Lösung denkbar, die Master-Laserdiode gekoppelt mit den Slave-Laserdioden, d. h. auch abgestimmt relativ zu diesen, zu betreiben. Besonders günstig ist es jedoch, wenn die Slave-Laserdioden unabhängig von der Master-Laserdiode betrieben werden, da dann die Möglichkeit besteht, die Master-Laserdiode auf die Slave-Laserdioden optimal abzustimmen.

Eine besonders günstige Lösung sieht dabei vor, daß mit der Master-Laserdiode das Gesamtlaserstrahlungsfeld modulierbar ist.

Dabei wäre einerseits denkbar, die Master-Laserstrahlung optisch, beispielsweise durch Strahlunterbrechung oder Strahlabschwächung oder Polarisationsdrehung, zu modulieren. Besonders günstig ist es jedoch, wenn die Master-Laserstrahlung durch den der Master-Laserdiode zugeführten Strom modulierbar ist, da damit durch eine kleine Stromänderung eine derartige Modulation der Master-Laserstrahlung möglich ist, die eine Abkopplung der Slave-Laserdioden von der Master-Laserdiode bewirkt, so daß die Slave-Laserdioden nicht mehr frequenz- und phasenstarr arbeiten und somit die kohärente Überlagerung der Slave-Laserstrahlungen zum Gesamtlaserstrahlungsfeld zusammenbricht, so daß letztlich eine kleine Strommodulation zu einer im wesentlichen vollständigen Intensitätsmodulation des Gesamtlaserstrahlungsfeldes führt.

Hinsichtlich des Betriebs der einzelnen Slave-Laserdioden wurden im Zusammenhang mit der bisherigen Erläuterung der einzelnen Ausführungsbeispiele keine detaillierten Angaben gemacht. So ist es besonders vorteilhaft, um die Abstimmung der Slave-Laserdioden relativ zueinander aufrechtzuerhalten, wenn alle Slave-Laserdioden unter identischen Temperaturbedingungen betrieben werden, beispielsweise auf einem gemeinsamen Träger oder Substrat angeordnet und durch dieses temperiert werden.

Besonders günstig ist es auch, wenn die Slave-Laserdioden und die Master-Laserdiode unter im wesentlichen identischen Temperaturbedingungen betrieben werden, so daß auch durch Temperatur ausgelöste Drifts der Master-Laserdiode relativ zu den Slave-Laserdioden vermieden werden.

Hinsichtlich der Ausbildung der Slave-Laserdioden hat es sich als besonders günstig erwiesen, wenn jede der Slave-Laserdioden hinsichtlich ihres Arbeitsbereichs als Slave-Laserdiode so ausgebildet wird, daß durch Einstellung des Stroms eine Resonanzfrequenz der Slave-Laserdiode eingestellt wird. Damit besteht durch die Einstellung des Stroms die Möglichkeit, die Resonanzfrequenz der jeweiligen Slave-Laserdiode zu ändern und somit diese auch hinsichtlich der Frequenz der Master-Laserstrahlung abzustimmen.

Besonders vorteilhaft ist es, wenn eine Phasenlage der Slave-Laserstrahlung jeder Slave-Laserdiode relativ zur Master-Laserstrahlung durch Einstellung des Stroms eingestellt wird, denn damit besteht die Möglichkeit, individuell die Phase der jeweiligen Slave-Laserdiode so abzustimmen, daß im Gesamtlaserstrahlungsfeld die Slave-Laserstrahlungen aller Slave-Laserdioden phasengleich überlagert werden können.

Weitere Merkmale und Vorteile der erfindungsgemäßen Lösung sind Gegenstand der nachfolgenden Beschreibung sowie der zeichnerischen Darstellung einiger Ausführungsbeispiele. In der Zeichnung zeigen:

Fig. 1    eine schematische Darstellung eines ersten Ausführungsbeispiels einer erfindungsgemäßen Laserstrahlungsquelle;

Fig. 2    eine schematische Darstellung von räumlicher Intensitätsverteilung und Phasenlage der Slave-Laserstrahlungen am Ort der Slave-Laserdiode;

Fig. 3    eine schematische Darstellung von räumlicher Intensitätsverteilung und Phasenlage der Slave-Laserstrahlungen nach Durchlaufen einer ersten Phasenplatte;

Fig. 4    eine schematische Darstellung von räumlicher Intensitätsverteilung und Phasenlage der Slave-Laserstrahlungen in der Fourierebene vor Eintritt in eine Phasenkorrekturplatte; und

Fig. 5     eine schematische Darstellung von räumlicher Intensitätsverteilung und Phasenlage der Slave-Laserstrahlungen im Gesamtlaserstrahlungsfeld nach Hindurchtritt durch die Phasenkorrekturplatte;

Fig. 6     ein zweites Ausführungsbeispiel einer erfindungsgemäßen Laserstrahlungsquelle;

Fig. 7     eine schematische Darstellung von räumlicher Intensitätsverteilung und Phasenlage der Slave-Laserstrahlungen am Ort der Slave-Laserdioden;

Fig. 8     eine schematische Darstellung von räumlicher Intensitätsverteilung und Phasenlage der Slave-Laserstrahlungen nach Durchtritt durch die Phasenplatte;

Fig. 9     eine schematische Darstellung von räumlicher Intensitätsverteilung und Phasenlage der Slave-Laserstrahlungen vor Eintritt in die Phasenkorrekturplatte; und

Fig. 10     eine schematische Darstellung von räumlicher Intensitätsverteilung und Phasenlage der Slave-Laserstrahlungen nach Durchtritt durch die Phasenkorrekturplatte;

Fig. 11     ein drittes Ausführungsbeispiel einer erfindungsgemäßen Laserstrahlungsquelle;

Fig. 12     ein viertes Ausführungsbeispiel einer erfindungsgemäßen Laserstrahlungsquelle;

Fig. 13     eine schematische Darstellung einer Schaltung einzelner Stromversorgungsnetzwerke für die einzelnen Slave-Laserdioden;

Fig. 14     einen ausschnittsweise vergrößerten Schnitt durch ein Substrat mit Vertikalemittern als Slave-Laserdioden;

Fig. 15     eine Draufsicht auf ein Substrat mit vertikalemittern entsprechend Fig. 14;

Fig. 16     eine schematische Darstellung eines Leiterabschnitts mit einer Unterbrechung;

Fig. 17     eine schematische Darstellung des Leiterabschnitts gemäß Fig. 16 mit Überbrückung der Unterbrechung;

Fig. 18     eine schematische Darstellung einer Resonanzkurve eines Vertikalemitters in Relation zur Master-Laserstrahlung;

Fig. 19     eine schematische Darstellung von relativer Phasenlage zwischen Master-Laserstrahlung und Slave-Laserstrahlung in Abhängigkeit von der Lage der Master-Laserstrahlung relativ zur Resonanzkurve der Slave-Laserdiode;

Fig. 20     eine schematische Darstellung eines Abstimmvorgangs der einzelnen Slave-Laserdioden aufeinander im Fall des vierten Ausführungsbeispiels;

Fig. 21     eine schematische Darstellung einer Phasenbeziehung zwischen in einer Richtung aufeinanderfolgenden Slave-Laserstrahlungen und

Fig. 22     eine schematische Darstellung von Dickenverhältnissen einer Phasenplatte bei der in Fig. 21 dargestellten Phasenbeziehung.

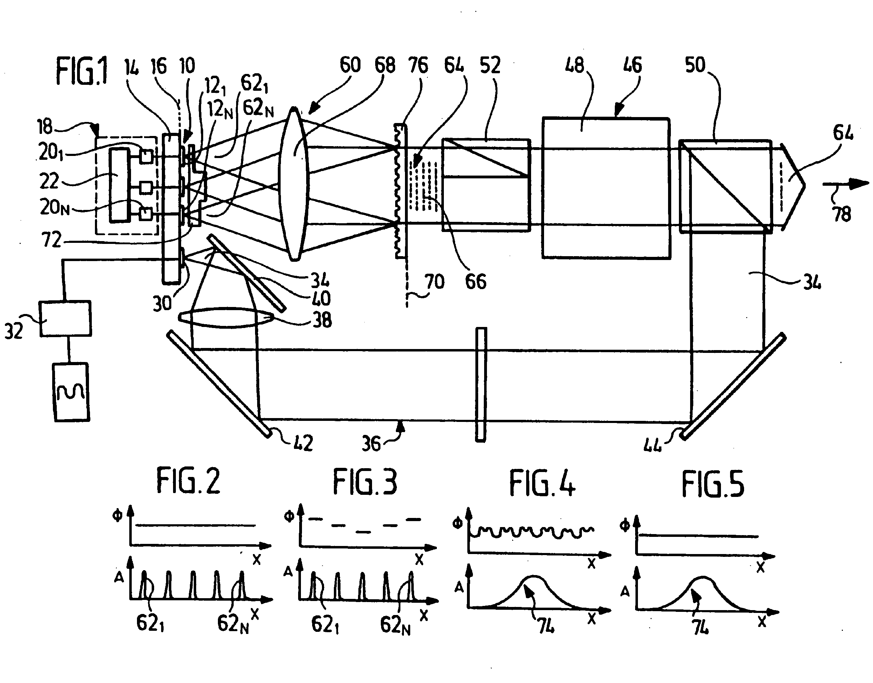

Ein erstes, schematisch in Fig. 1 dargestelltes Ausführungsbeispiel einer erfindungsgemäßen Laserstrahlungsquelle umfaßt eine als Ganzes mit 10 bezeichnete zweidimensionale Anordnung von Slave-Laserdioden $12_1$ bis $12_N$, welche vorzugsweise auf einem gemeinsamen Substrat 14 angeordnet sind und dabei in einer gemeinsamen Ebene 16 liegen.

Alle diese Slave-Laserdioden $12_1$ bis $12_N$ sind durch eine gemeinsame Slave-Stromversorgung 18 betreibbar, wobei die Slave-Stromversorgung 18 für jede der Slave-Laserdioden $12_1$ bis $12_N$ ein eigenes Stromversorgungsnetzwerk $20_1$ bis $20_N$ aufweist.

Alle Stromversorgungsnetzwerke $20_1$ bis $20_N$ sind parallelgeschaltet und durch eine einzige Spannungsquelle 22 gespeist.

Außerdem ist auf dem Substrat 14 noch eine Master-Laserdiode 30 vorgesehen, welche mittels einer Master-Stromversorgung 32 betreibbar ist.

Die Master-Laserdiode emittiert eine Master-Laserstrahlung 34, welche mittels einer Kopplungsoptik 36, umfassend eine Kollimationsoptik 38, Umlenkspiegel 40, 42 und 44 sowie ein Entkopplungselement 46, gebildet aus einem Faradayrotator 48 und beiderseits desselben angeordneten Polarisationsprismen 50 und 52, sowie eine als Ganzes mit 60 bezeichnete Transformationsoptik in alle Slave-Laserdioden $12_1$ bis $12_N$ angekoppelt wird, so daß alle Slave-Laserdioden $12_1$ bis $12_N$ mit derselben Wellenlänge wie die Master-Laserstrahlung 34 und phasenstarr mit dieser arbeiten.

Alle Slave-Laserdioden $12_1$ bis $12_N$ emittieren jeweils eine Slave-Laserstrahlung $62_1$ bis $62_N$, welche durch die Transformationsoptik 60 in eine Gesamtlaserstrahlung 64 mit in Fernfeldnäherung definierten, vorzugsweise im wesentlichen ebenen Wellenfronten 66 transformiert wird.

Hierzu ist eine Fourieroptik 68 vorgesehen, welche von der Ebene 16 in einem der Brennweite F entsprechenden Abstand angeordnet ist und die Slave-Laserstrahlungen $62_1$ bis $62_N$ aller Slave-Laserdioden $12_1$ bis $12_N$ in eine Fourierebene 70 abbildet, welche auf der der Ebene 16 gegenüberliegenden Seite der Fourieroptik 68 im Abstand mit der Brennweite F angeordnet ist.

Arbeiten nun alle Slave-Laserdioden $12_1$ bis $12_N$ auf derselben Wellenlänge unter Emission der Slave-Laserstrahlungen $62_1$ bis $62_N$, so haben alle diese Slave-Laserstrahlungen, wie in Fig. 2 über einer Raumkoordinate X schematisch dargestellt, beim Austritt aus den Slave-Laserdioden $12_1$ bis $12_N$ theoretisch dieselbe Phasenlage relativ zueinander.

Um in der Fourierebene 70 eine näherungsweise gaussförmige Überlagerung aller Slave-Laserstrahlungen $62_1$ bis $62_N$ zu erhalten, wird den Slave-Laserstrahlungen $62_1$ bis $62_N$ unmittelbar nach ihrem Austritt aus den einzelnen Slave-Laserdioden $12_1$ bis $12_N$ mittels einer Phasenplatte 72 eine unterschiedliche Phasenlage relativ zueinander gegeben, wie dies in Fig. 3 dargestellt ist.

Durch die relativ zueinander unterschiedliche Phasenlage entsteht in der Fourierebene 70, wie in Fig. 4 dargestellt, eine über der Raumkoordinate X im wesentlichen gaussförmige Verteilung der Intensität A durch Überlagerung sämtlicher Slave-Laserstrahlungen $62_1$ bis $62_N$, die aufgrund der unterschiedlichen Phasenlage eine geringe Intensitätsmodulation aufweisen. Allerdings variiert die Phasenlage, wie ebenfalls in Fig. 4 dargestellt, über der Raumkoordinate trotz der gaussförmigen Intensitätsverteilung.

Um diese unterschiedlichen Phasenlagen auszugleichen, ist in der Fourierebene 70 die Phasenkorrekturplatte 76 vorgesehen, welche, wie in Fig. 5 dargestellt, dafür sorgt, daß nach Durchtritt der Slave-Laserstrahlungen $62_1$ bis $62_N$ diese wieder relativ zueinander dieselbe Phasenlage aufweisen, wie in Fig. 5 dargestellt, zusätzlich zu der gaussförmigen Intensitätsverteilung 74, so daß sich alle Slave-Laserstrahlungen $62_1$ bis $62_N$ kohärent mit gleicher Phasenlage zu dem Gesamtlaserstrahlungsfeld 64 mit den im Fernfeld im wesentlichen ebenen Wellenfronten 66 überlagern.

Das Entkopplungselement 46 bewirkt nun, daß dieses Laserstrahlungsfeld 64 eine derartige Drehung der Polarisationsebene erfährt, daß dieses ohne Auskopplung durch das Polarisationsprisma 50 hindurchtritt, durch welches die Master-Laserstrahlung 34 quer zu der Ausbreitungsrichtung 78 des Gesamtlaserstrahlungsfelds 64 eingekoppelt wird und das Entkopplungselement 46 entgegengesetzt zur Ausbreitungsrichtung 78 in Richtung der Anordnung 10 der Slave-Laserdioden $12_1$ bis $12_N$ durchsetzt.

Eine nähere Beschreibung der Erzeugung des Gesamtlaserstrahlungsfeldes 64 mittels der Transformationsoptik 70 ergibt sich aus dem Artikel von P. EHBETS, H.P. HERZIG, R. DÄNDLIKER, P. REGNAULT und I. KJELBERG mit dem Titel "Beam shaping of high-power laser diode arrays by continuous surface-relief elements" in Journal of Modern Optics, 1993, Volume 40, Nr. 4, Seiten 637 - 645.

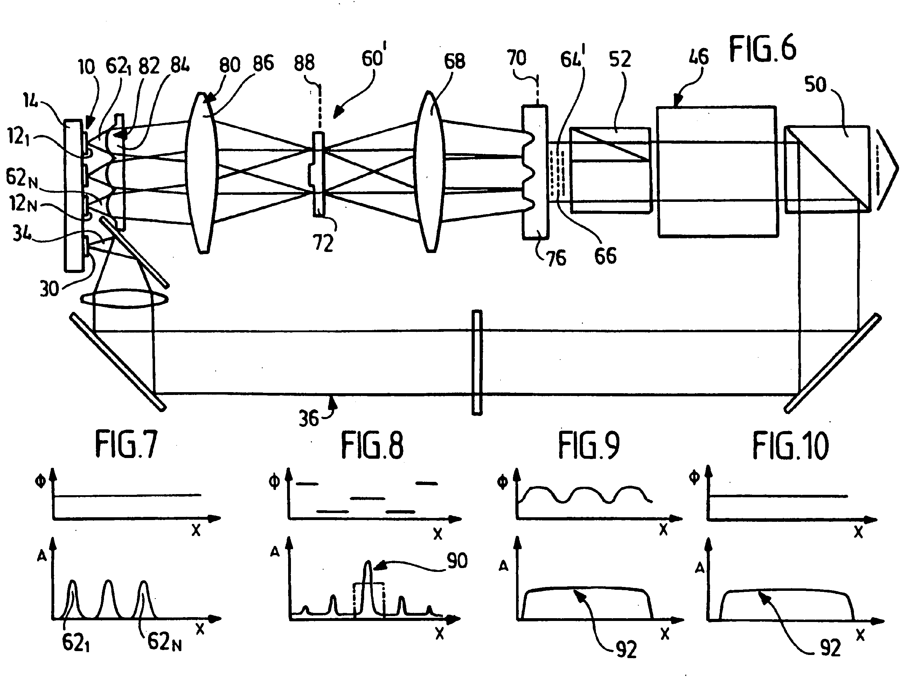

Bei einem zweiten Ausführungsbeispiel einer erfindungsgemäßen Laserstrahlungsquelle, dargestellt in Fig. 6, sind diejenigen Elemente, die mit denen des ersten Ausführungsbeispiels identisch sind, mit denselben Bezugszeichen versehen, so daß hinsichtlich der Beschreibung derselben auf die Ausführungen zum ersten Ausführungsbeispiel vollinhaltlich Bezug genommen werden kann.

Im Gegensatz zum ersten Ausführungsbeispiel umfaßt die Transformationsoptik 60' nicht nur die Fourieroptik 68 mit der Phasenplatte 72 und der Phasenkorrekturplatte 76, sondern noch eine dieser vorgeschaltete Zwischenoptik 80 mit einem Satz 82 von den Slave-Laserdioden 12 zugeordneten Einzellinsen 84, welche die jeweilige Slave-Laserstrahlung $62_1$ bis $62_N$ einzeln kollimiert. Eine nachgeordnete Optik 86 überlagert ihrerseits in einer Ebene 88 alle Slave-Laserstrahlungen $62_1$ bis $62_N$ miteinander. Dabei ergibt sich, ausgehend von den in Fig. 7 dargestellten, aus den Slave-Laserdioden $12_1$ bis $12_N$ austretenden Slave-Laserstrahlungen $62_1$ bis $62_N$ mit theoretisch relativ zueinander gleicher Phasenlage eine mit der Raumkoordinate X variierende Intensitätsverteilung 90 (Fig. 8).

Da in der Abbildungsebene 88 die Phasenplatte 72 angeordnet ist, verleiht diese den einzelnen Intensitätsmaxima eine unterschiedliche Phasenlage, so dass in der Ebene 70, in der die Phasenkorrekturplatte 76 angeordnet ist, ein sogenanntes flat-top-Profil 92 der Intensität A bezogen auf die räumliche Verteilung entsteht, allerdings wiederum mit variierender Phasenlage, wie in Fig. 9 dargestellt ist. Diese variierende Phasenlage wird durch die Phasenkorrekturplatte 76 ausgeglichen, so dass insgesamt das Gesamtstrahlungsfeld 64', wie in Fig. 10 dargestellt, eine relativ zueinander identische Phasenlage der einzelnen Slave-Laserstrahlungen $62_1$ bis $62_N$ aufweist und die Intensitätsverteilung die Form des flat-top-Profils 92 hat, so dass sich alle diese Slave-Laserstrahlungen $62_1$ bis $62_N$ kohärent überlagern und das Gesamtlaserstrahlungsfeld 64' mit im Fernfeld ebenen Wellenfronten 66 bilden.

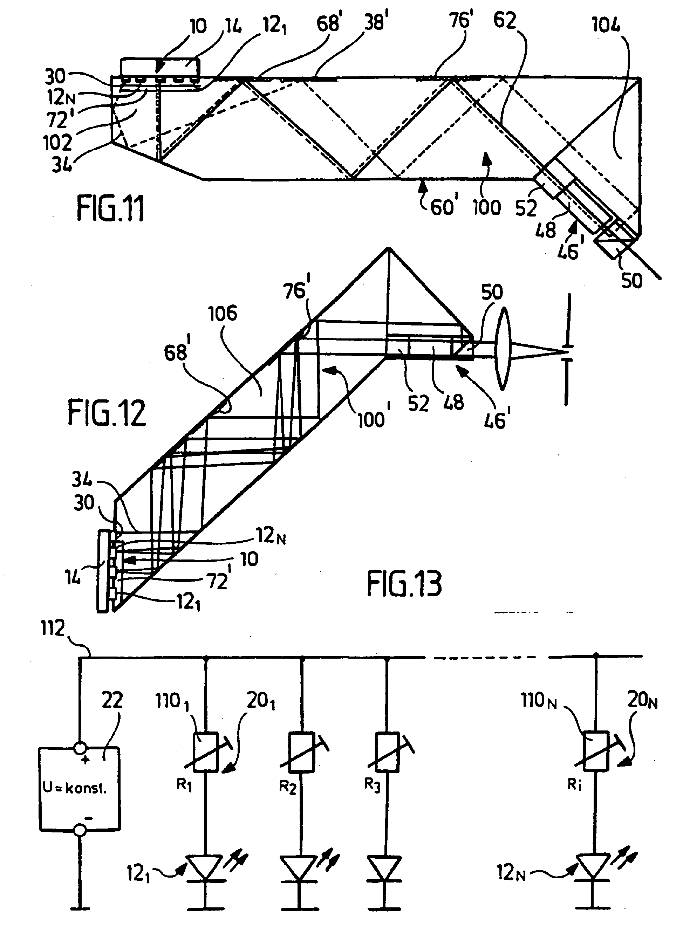

Bei einem dritten Ausführungsbeispiel einer erfindungsgemäßen Laserstrahlungsquelle, dargestellt in Fig. 11, ist die Kopplungsoptik 36 mit der Transformationsoptik 60, beispielsweise aufgebaut entsprechend dem ersten, in Fig. 1 in konventionellem Aufbau schematisch dargestellten Ausführungsbeispiel, in einen gemeinsamen Block 100 integriert, welcher vorteilhafterweise eine Einheit bildet.

An einem Endbereich 102 des Blocks 100 ist die Anordnung 10 der einzelnen Slave-Laserdioden $12_1$ bis $12_N$ und die Master-Laserdiode 30 vorgesehen, wobei die Slave-Laserstrahlung 62 beispielsweise unmittelbar in den Block 100 im Bereich des Endes 102 eintritt, und die Anordnung 10 gegenüber dem Block 100 fixiert ist.

Nach einer ersten Reflexion trifft die Slave-Laserstrahlung 62 auf die als diffraktives optisches Element ausgebildete Fourieroptik 68', und schließlich nach einer weiteren Reflexion auf die Phasenkorrekturplatte 76', ebenfalls ausgeführt als diffraktives optisches Element.

Im Anschluss daran tritt die Slave-Laserstrahlung 62 durch das Entkopplungselement 46', welches ebenfalls als in den Block 100 im Bereich eines Endes 104 eingebautes Element ausgebildet ist.

In gleicher Weise wird die Master-Laserstrahlung 34 in dem Block 100 geführt und trifft auf die Kollimationsoptik 38', ebenfalls ausgeführt als diffraktives optisches Element, und tritt nach mehrfacher Reflexion in das Polarisationsprisma 50 ein und wird von diesem, in gleicher Weise wie im Zusammenhang mit Fig. 1 erläutert, in die Transformationsoptik 60' eingekoppelt.

Bei einem vierten Ausführungsbeispiel einer erfindungsgemäßen Laserstrahlungsquelle, dargestellt in Fig. 12, ist der Block 100' in einem Teilabschnitt 106 als in der äußeren Form parallelogrammförmiger Block ausgebildet, wobei die zweidimensionale Anordnung 10 der Slave-Laserdioden $12_1$ bis $12_N$ an einer kurzen Seite des Parallelogramms angeordnet ist.

Die einzelnen optischen Elemente sind ebenfalls als diffraktive optische Elemente in gleicher Weise wie beim dritten Ausführungsbeispiel ausgebildet.

Die Master-Laserstrahlung 34 der Master-Laserdiode 30 wird in dem Block 100' ebenfalls gegenüber den Slave-Laserstrahlungen 62 versetzt so geführt, daß eine Einkopplung über das Polarisationsprisma 50 des Entkopplungselements 46' erfolgt.

Im übrigen sind dieselben Elemente mit denselben Bezugszeichen versehen, so daß hinsichtlich der Beschreibung derselben auf die Ausführungen zu den voranstehenden Ausführungsbeispielen vollinhaltlich Bezug genommen werden kann.

Im Zusammenhang mit der bisherigen Erläuterung der einzelnen Ausführungsbeispiele wurde nicht näher darauf eingegangen, wie die einzelnen Stromversorgungsnetzwerke $20_1$ bis $20_N$ für die einzelnen Slave-Laserdioden $12_1$ bis $12_N$ ausgebildet sein sollen.

Im einfachsten Fall sind - wie in Fig. 13 dargestellt - die Stromversorgungsnetzwerke $20_1$ bis $20_N$ mit den jeweiligen Slave-Laserdioden $12_1$ bis $12_N$ in Reihe geschaltete Widerstände $110_1$ bis $110_N$, die über eine Speiseleitung 112 mit der Konstantspannungsquelle 22 verbunden sind, während andererseits die Slave-Laserdioden $12_1$ bis $12_N$ ihrerseits auf Masse liegen.

Um die jeweiligen Vertikalemitter 120 mit gleicher Polarisation quer zur Ausbreitungsrichtung 150 der Laserstrahlung arbeiten zu lassen, können diese hinsichtlich ihrer Querschnittsform in Ebenen senkrecht zur Ausbreitungsrichtung 150 abweichend von einer kreisrunden Form gestaltet sein. Beispielsweise ist die Form oval oder weicht einseitig von einem kreisförmigen Querschnitt ab. Alternativ kann auch durch geeignete Kristallorientierung des Substrats die Polarisationsrichtung weitgehend stabilisiert werden.

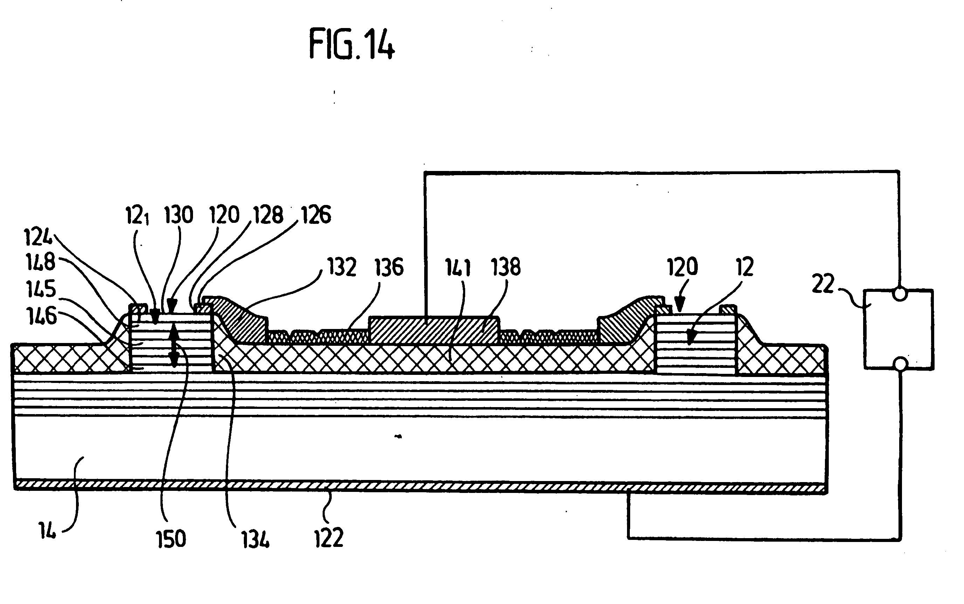

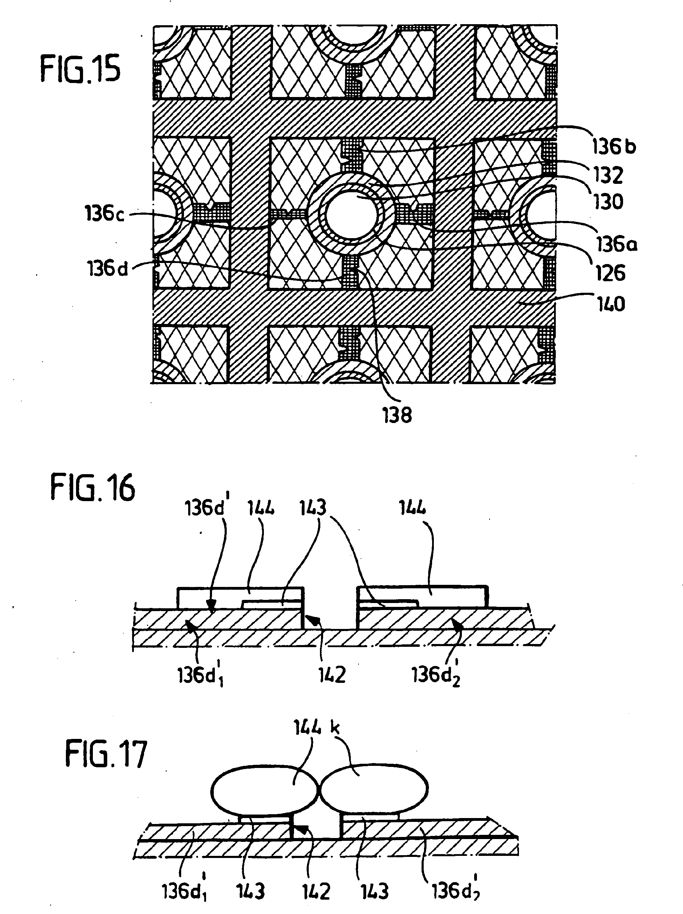

Eine Stromversorgung der einzelnen Slave-La-serdioden $12_1$ bis $12_N$ läßt sich, wie in Fig. 14 und 15 dargestellt, bei Vertikalemittern 120 als Laserdioden, insbesondere als Slave-Laserdioden 12, dadurch realisieren, daß diese Vertikalemitter 120 auf dem gemeinsamen Substrat 14 angeordnet sind, welches seinerseits auf einer gemeinsamen Kontaktschicht 122 liegt, wobei die gemeinsame Kontaktschicht 122 die Masseschicht darstellt, über welche jeder einzelne Vertikalemitter 120 durch die Substratschicht 14 hindurch mit der Masse verbunden ist.

Eine Stromzuführung zu jedem einzelnen Vertikalemitter 120 erfolgt über einen auf eine oberste Schicht 124 des jeweiligen Vertikalemitters 120 aufgelegten Kontaktring 126, welcher einen Durchbruch 128 aufweist, der eine Austrittsfläche 130 für die jeweilige Laserstrahlung freigibt.

Jeder Kontaktring 126 eines derartigen Vertikalemitters 120 wird seinerseits kontaktiert mit einem äußeren Verbindungsring 132, welcher den jeweiligen Vertikalemitter 120 umschließt und vorzugsweise auf einer diesen umgebenden Isolationsschicht 134 aufliegt.

Zu dem äußeren Kontaktring 132 führen abstimmbare Leitungsabschnitte 136, welche zwischen dem äußeren Kontaktring 132 und einem Netz von einander kreuzenden Leiterbahnen 138 und 140 liegen, die auf einer sich zwischen den einzelnen Vertikalemittern 120 erstreckenden Isolationsschicht 141 aufliegen.

Vorzugsweise ist jeder äußere Ring 132 durch vier Leitungsabschnitte 136a, 136b, 136c und 136d mit dem Netz der sich kreuzenden Leiterbahnen 138 und 140 verbunden, wobei die Leitungsabschnitte 136a bis 136d vorzugsweise bereits in ihrer Grundform unterschiedliche Querschnitte aufweisen, die zusammen den mit der jeweiligen Slave-Laserdiode 12 in Reihe geschalteten Widerstand 110 bilden. Alle diese Leitungsabschnitte 136a bis 136d sind beispielsweise durch einen Laserstrahl trimmbar, wobei das Trimmen durch Einbringen von Ausnehmungen 138 in die Leitungsabschnitte 136a bis 136d erfolgt, wobei diese Ausnehmungen 138 eine zusätzliche Querschnittsreduktion und somit eine Widerstandserhöhung zur Folge haben.

Aufgrund der bereits in ihrer Grundform unterschiedlichen Querschnitte der Leitungsabschnitte 136a bis 136d sind durch Einbringen der Ausnehmungen 138 unterschiedliche Widerstandsvariationen erzielbar, so daß eine grobe oder weniger grobe Feinabstimmung des Gesamtwiderstands aller Leitungsabschnitte 136a bis 136d für einen Vertikalemitter 120 erreichbar ist.

Ergänzend oder alternativ zur Reduzierung der Querschnitte in den Leitungsabschnitten 136a bis 136d ist es aber ebenfalls denkbar, beispielsweise den Leitungsabschnitt 136d' mit einer Unterbrechung 142 zu versehen, so daß Leitungsabschnittstücke 136d'1 und 136d'2 entstehen, die aufgrund der Unterbrechung 142 nicht stromleitend sind (Fig. 16).

Jedes der Leitungsabschnittstücke 136d'1 und 136d'2 trägt nahe der Unterbrechung 142 eine nicht benetzbare Schicht 143, beispielsweise aus Platin, und diese ist wiederum überdeckt von einer Lotschicht 144.

Wird die Lotschicht 144 durch Wärmeeinwirkung, beispielsweise durch einen Laserstrahl, aufgeschmolzen, so entstehen, wie in Fig. 17 dargestellt, aufgrund der Nichtbenetzbarkeit der Schicht 143 Lotkugeln 144k, welche in der Lage sind, die Unterbrechung 142 zu überbrücken, so daß dann insgesamt die Stromleitung von dem Leitungsabschnittstück 136d'1 über die nicht benetzbare Schicht 143, die sich berührenden Lotkugeln 144k, die nicht benetzbare Schicht 143 zum Leitungsabschnittstück 136d'2 erfolgt.

Dabei kann die Größe der Lotkugeln 144k vorzugsweise durch Dicke und Ausdehnung der Lotschicht 144 vor deren Aufschmelzen festgelegt werden.

Somit besteht die Möglichkeit, den mit der Unterbrechung 142 versehenen Leitungsabschnitt 136d', der zunächst den Widerstand unendlich aufweist, leitend zu gestalten und somit insgesamt den Widerstand zu erniedrigen, wobei dabei nicht ausgeschlossen wird, daß auch der Leitungsabschnitt 136d' beispielsweise an einer anderen Stelle wiederum durch Anbringen einer Ausnehmung 138 ebenfalls wieder hinsichtlich seines Widerstands reduziert wird.

Das Netzwerk der sich kreuzenden Leiterbahnen 138 und 140 ist, wie in Fig. 14 dargestellt, mit der Spannungsquelle 22 verbunden, welche vorzugsweise als Konstantspannungsquelle ausgebildet ist.

Bei einer derartigen Stromspeisung sämtlicher Slave-Laserdioden $12_1$ bis $12_N$ sind geringe Schwankungen der Spannung der Spannungsquelle 22 unerheblich, da der Strom durch alle Slave-Laserdioden $12_1$ bis $12_N$ in gleicher Weise ansteigt oder abnimmt und somit der relative Abgleich der Slave-Laserdioden $12_1$ bis $12_N$ bestehen bleibt.

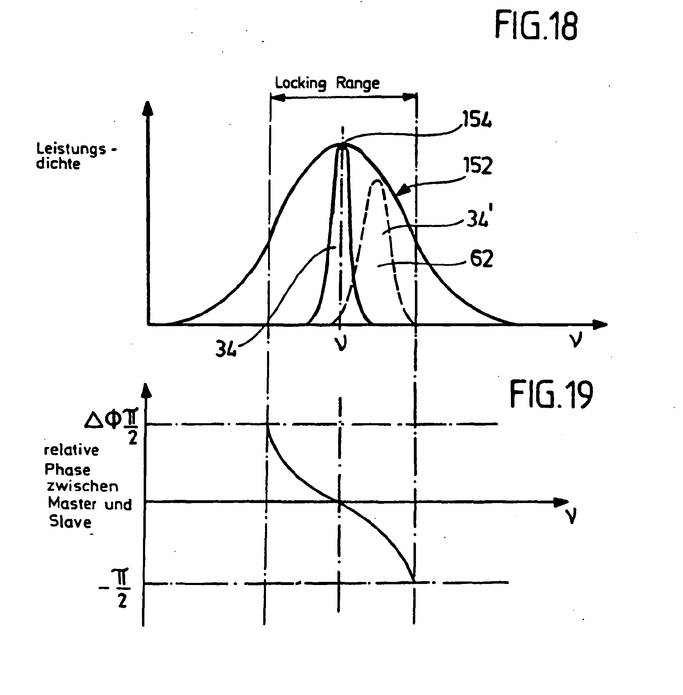

Die Einstellung des Stroms durch die jeweilige Slave-Laserdiode $12_1$ bis $12_N$ hat nun, wie in Fig. 18 dargestellt, zur Folge, daß sich der optische Weg im Schichtensystem 145, 146, 148 des Vertikalemitters 120 in Ausbreitungsrichtung 150 der entstehenden Slave-Laserstrahlung 62 ändert und somit auch die Resonanzkurve 152 des in dem jeweiligen Vertikalemitter 120 vorgesehenen optischen Resonators, welche beispielsweise durch als Schichten im Vertikalemitter ausgebildete Bragg-Gitter 146 und 148 gebildet ist.

Damit läßt sich die Resonanzkurve 152 des jeweiligen in dem Vertikalemitter 120 vorhandenen Resonators 146, 148 auf der Frequenzachse verschieben. Soll nun beispielsweise eine Abstimmung des jeweiligen Vertikalemitters 120 auf die jeweilige Master-Laserstrahlung 34 erfolgen, so läßt sich die Resonanzkurve 152 - wie in Fig. 18 dargestellt - beispielsweise so verschieben, daß die Wellenlänge der Master-Laserstrahlung 34 im wesentlichen im Maximum 154 der Resonanzkurve 152 liegt.

In diesem Fall ist die Frequenz der freilaufenden Slave-Laserdiode 12 identisch mit der Frequenz der Master-Laserdiode 30.

Es besteht aber auch die Möglichkeit, die Resonanzkurve 152 des Resonators 146, 148 relativ zur Master-Laserstrahlung 34 so zu verschieben, daß, wie ebenfalls in Fig. 18 durch die Master-Laserstrahlung 34' dargestellt, die Master-Laserstrahlung 34' neben dem Maximum 154 liegt. Dies ist soweit möglich, solange die Relativverschiebung so klein ist, daß die Master-Laserstrahlung 34' noch innerhalb eines Arbeitsbereichs oder "locking range" der Resonanzkurve 152 liegt.

Dadurch läßt sich, wie in Fig. 19 dargestellt, die relative Phasenlage zwischen der Master-Laserstrahlung 34 und der Slave-Laserstrahlung 62 abstimmen.

Ist beispielsweise bei einem der Vertikalemitter 120 die Phasenlage der Slave-Laserstrahlung 62 relativ zur Master-Laserstrahlung 34, die bei allen Vertikalemittern 120 hinsichtlich ihrer Frequenz identisch ist, zu variieren, so wird bei diesem Vertikalemitter 120 durch Abstimmung des Stroms die Resonanzkurve 152 so weit verschoben, bis die Slave-Laserdiode 12 mit der gewünschten Phasendifferenz zur Master-Laserstrahlung 34 arbeitet und folglich auch die Slave-Laserstrahlung 62 diese Phasendifferenz aufweist, wobei die Frequenz der Master-Laserstrahlung 34 nach wie vor bei allen Vertikalemittern 120 dieselbe ist und somit alle Vertikalemitter 120 auf der Frequenz der Master-Laserstrahlung 34 arbeiten.

Damit läßt sich eine exakte Abstimmung der Phasenlage aller Slave-Laserdioden $12_1$ bis $12_N$ relativ zueinander erreichen, um im Gesamtlaserstrahlungsfeld 64 eine kohärente phasengleiche Überlagerung aller Slave-Laserstrahlungen 62 erhalten zu können.

Insbesondere lassen sich mit einer derartigen Abstimmung der Phasenlage des jeweiligen Vertikalemitters 120 auch Phasenverschiebungen durch nachfolgende optische Komponenten, insbesondere die Transformationsoptik 60, mit der Phasenplatte 72 und der Phasenkorrekturplatte 76 ebenfalls ausgleichen.

Die relative Phasenlage der einzelnen Slave-Laserdioden $12_1$ bis $12_N$ läßt sich dabei beispielsweise dadurch abstimmen, daß bei Betrieb aller Slave-Laserdioden $12_1$ bis $12_N$ auf der Frequenz der Master-Laserstrahlung 34, d. h. mit arbeitender Master-Laserdiode 30, jeweils die Intensität des fokussierten Gesamtlaserstrahlungsfeldes 64 von nur zwei der Slave-Laserdioden $12_1$ bis $12_N$ gemessen und maximiert wird. Dabei wird eine der Slave-Laserdioden $12_1$ bis $12_N$ als Referenz herangezogen, beispielsweise die Slave-Laserdiode $12_1$, und auf diese als Referenz arbeitende Slave-Laserdiode $12_1$ werden alle übrigen Slave-Laserdioden $12_2$ bis $12_N$ hinsichtlich ihrer Phasenlage abgestimmt, beispielsweise so, daß die Referenz-Slave-Laserdiode $12_1$ und jeweils eine der übrigen Slave-Laserdioden $12_2$ bis $12_N$ mit der Master-Laserstrahlung 34 betrieben werden und nur deren Intensität im fokussierten Gesamtlaserstrahlungsfeld 64 gemessen wird. Ist die Intensität maximal, so stimmen die Phasen der beiden Slave-Laserstrahlungen $62_1$ und $62_{2-N}$ überein.

Der Abgleich des jeweils entsprechenden Widerstands aus den Widerständen $110_2$ bis $110_N$ erfolgt dabei jeweils so lange, bis eine phasengleiche Überlagerung der beiden jeweiligen Slave-Laserstrahlungen 62 erreicht ist.

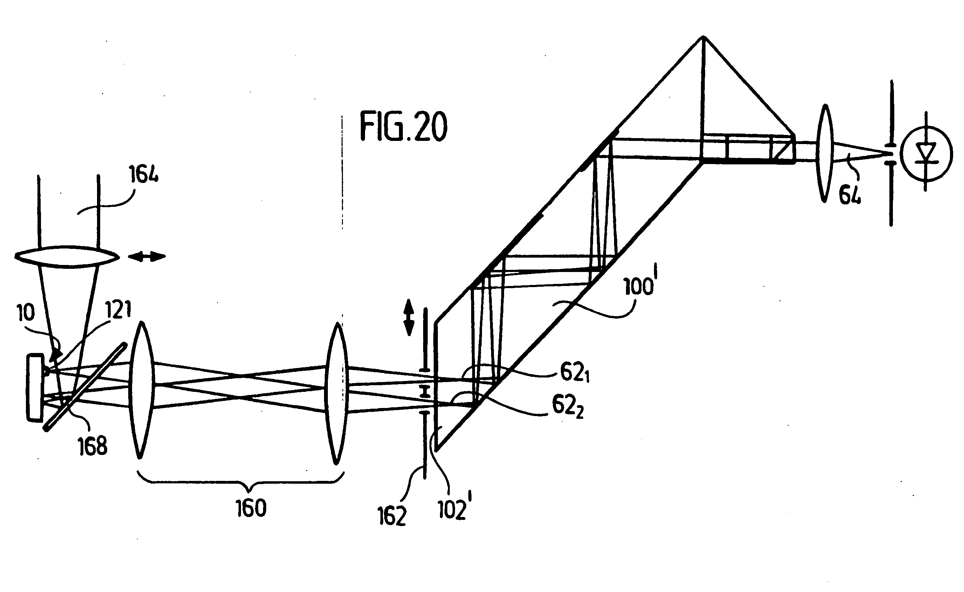

Eine Möglichkeit der Durchführung eines derartigen Abgleichs ist anhand des vierten Ausführungsbeispiels in Fig. 20 exemplarisch dargestellt. Zum Abgleich wird die Anordnung 10 der Slave-Laserdioden $12_1$ bis $12_N$ im Abstand von der entsprechenden Fläche des Blocks 100' seitenverkehrt angeordnet und über eine Zwischenabbildungsoptik 160 so abgebildet, als ob die Anordnung 10 unmittelbar an dem Block 100' im Bereich des Endes 102' anliegen würde.

Durch die Zwischenabbildungsoptik 160 besteht die Möglichkeit, beispielsweise mit einer Blende 162, jeweils zwei Slave-Laserstrahlungen, beispielsweise die Slave-Laserstrahlung $62_1$ und die Slave-Laserstrahlung $62_2$, auszuwählen und die übrigen Slave-Laserstrahlungen $62_3$ bis $62_N$ auszublenden. Gleichzeitig wird jedoch dafür Sorge getragen, daß die Master-Laserstrahlung 34 nach wie vor beide Slave-Laserdioden $12_1$ und $12_2$ auf derselben Frequenz hält.

Zum Abstimmen besteht nun aufgrund der Zwischenabbildungsoptik 160 die Möglichkeit, einen Abstimmlaserstrahl 164 mittels eines halbdurchlässigen Spiegels 168 auf die jeweilige Slave-Laserdiode 12, in diesem Fall die Slave-Laserdiode $12_2$, zu richten, um Ausnehmungen 138 in einen der Leitungsabschnitte 136a bis 136d einzubringen und/oder eine Unterbrechung 142 im Leitungsabschnitt 136d' zu überbrücken und somit die Slave-Laserdiode $12_2$ abzustimmen, und zwar so, daß das fokussierte Gesamtlaserstrahlungsfeld 64 eine maximale Intensität zeigt.

In gleicher Weise wird dann mit den übrigen Slave-Laserdioden $12_3$ bis $12_N$ verfahren, so daß nach Beendigung des Abstimmvorgangs alle Slave-Laserdioden $12_2$ bis $12_N$ auf die Referenz-Slave-Laserdiode $12_1$ abgestimmt sind und phasengleich mit dieser arbeiten.

Durch die unabhängige Master-Stromversorgung 32 besteht ferner noch die Möglichkeit, durch Variation des in die Master-Laserdiode 30 eingespeisten Stroms die Intensität der Gesamtlaserstrahlung 64 zu minimieren, wobei die Stromänderung sehr gering sein kann, da eine geringe Stromvariation dazu ausreicht, entweder die Frequenz der Master-Laserstrahlung 34 so weit zu verschieben, daß diese außerhalb der Resonanzkurven 152 aller Slave-Laserdioden $12_1$ bis $12_N$ liegt, so daß die Slave-Laserdioden $12_1$ bis $12_N$ nicht mehr auf derselben Frequenz arbeiten und somit auch eine kohärente Überlagerung aller Slave-Laserstrahlungen 62 zum Gesamtlaserstrahlungsfeld nicht mehr stattfindet. Damit bricht die Intensität des Gesamtlaserstrahlungsfeldes 64 zusammen.

Es besteht aber auch die Möglichkeit, den Strom für die Master-Laserdiode 30 soweit zu variieren, daß diese keine Master-Laserstrahlung 34 mehr abgibt und somit ebenfalls sämtliche Slave-Laserdioden $12_1$ bis $12_N$ nicht mehr auf derselben Frequenz arbeiten.

Somit besteht bei der erfindungsgemäßen Lösung die einfache Möglichkeit, bereits durch geringe Stromvariationen eine hohe Modulationstiefe in der Intensität des Gesamtlaserstrahlungsfeldes 64 zu erreichen.

Hinsichtlich der Ausbildung der Phasenplatte 72 und der entsprechenden komplementären Ausbildung der Phasenkorrekturplatte 76 wurden im Zusammenhang mit der bisherigen Erläuterung der einzelnen Ausführungsbeispiele keine näheren Angaben gemacht. So wäre es beispielsweise denkbar, die Phasenplatte 72 so auszubilden, daß die einzelnen Slave-Laserstrahlungen 62 eine statistisch variierende unterschiedliche Phase erhalten.

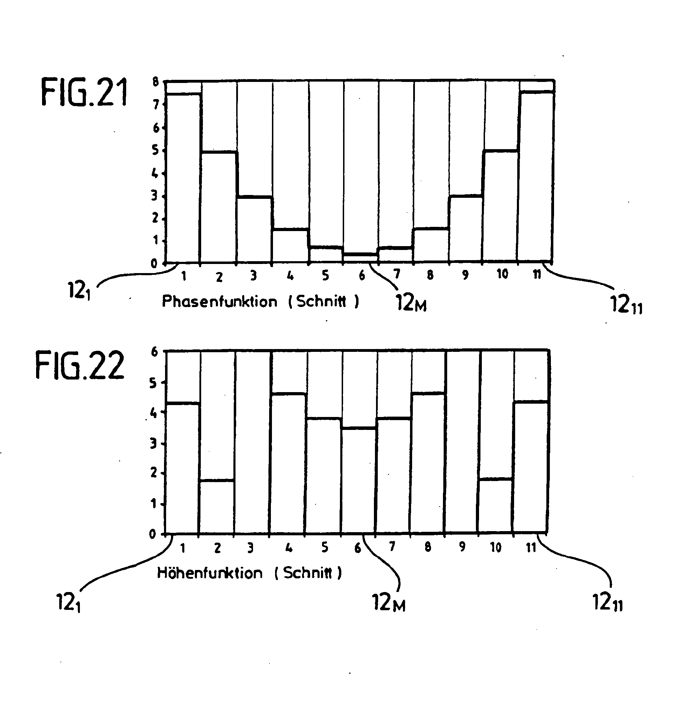

Um eine hohe Effizienz im Gesamtlaserstrahlungsfeld 64 zu erreichen, hat es sich jedoch als besonders vorteilhaft erwiesen, wenn die Phasenplatte 72 so ausgebildet ist, daß die Phase, wie in Fig. 21 dargestellt, ausgehend von einem mittleren Bereich zu Randbereichen, und zwar nach allen Richtungen als monoton verlaufende analytische Funktion variiert, wobei als Referenz eine mittlere Slave-Laserdiode $12_N$ der Anordnung 10 dient, von welcher ausgehend sich die Phasenunterschiede quadratisch vergrößern, beispielsweise durch die Funktion

$$\varphi = \frac{\pi \cdot \left( (i - i0)^2 + (j - j0)^2 \right)}{\sqrt{N}} \quad,$$

wobei i0 und j0 die Koordinaten der mittleren Slave-Laserdiode $12_M$ sind und i und j die Koordinaten der jeweiligen Slave-Laserdiode 12 darstellen.

Diese Phasenunterschiede können dann, wenn sie den Wert $2\pi$ übersteigen, dadurch noch berichtigt werden, daß der Wert $2\pi$ in diesem Fall abgezogen wird, so daß sich beispielsweise das in Fig. 22 dargestellte Muster die Dicke der Phasenplatte 72 für die einzelnen Slave-Laserstrahlungen 62 ergibt, welche die gewünschte Phasenbeziehung zwischen den einzelnen Slave-Laserstrahlungen 62 liefert.

**Patentansprüche**

1. Laserstrahlungsquelle umfassend eine Anordnung von N einzelnen Slave-Laserdioden (12) in einer vorgegebenen Fläche, eine Slave-Stromversorgung (18) für die Slave-Laserdioden (12), eine Master-Laserdiode (30) zur Erzeugung einer Master-Laserstrahlung (34), eine Master-Stromversorgung (32) für die Master-Laserdiode (30), eine Kopplungsoptik (36), mit welcher die Master-Laserstrahlung (34) in die einzelnen Slave-Laserdioden (12) einkoppelbar ist, um diese bei der Frequenz der Master-Laserdiode (30) phasenstarr zu betreiben, und eine Transformationsoptik (60), welche die Slave-Laserstrahlung (62) der einzelnen Slave-Laserdioden (12) zu einem kohärenten Gesamtlaserstrahlungsfeld (64) mit im Wesentlichen ebenen Wellenfronten (66) vereinigt, **dadurch gekennzeichnet, dass** die Slave-Stromversorgung (18) für jede Slave-Laserdiode (12) ein eigenes Stromversorgungsnetzwerk (20) aufweist, dass jedes der Stromversorgungsnetzwerke (20) hinsichtlich des der jeweiligen Slave-Laserdiode (12) während einer bestimmten Betriebsdauer zugeführten Stroms zur Abstimmung der Slave-Laserdioden (12) relativ zueinander abgleichbar ist, dass die Stromversorgungsnetzwerke (20) parallelgeschaltet und durch eine gemeinsame Quelle (22) gespeist sind und dass die Kopplungsoptik (36) ein Entkopplungselement (46) aufweist, durch welches die Master-Laserstrahlung (34) in die Slave-Laserdioden (12) eingekoppelt wird und welches das Gesamtlaserstrahlungsfeld (64) auskopplungsfrei durchsetzt.

2. Laserstrahlungsquelle nach Anspruch 1, **dadurch gekennzeichnet, dass** jedes der Stromversorgungsnetzwerke (20) einmalig durch Trimmung abgleichbar ist.

3. Laserstrahlungsquelle nach Anspruch 1 oder 2, **dadurch gekennzeichnet, dass** jedes der Stromversorgungsnetzwerke (20) ein Widerstandsnetzwerk ist.

4. Laserstrahlungsquelle nach Anspruch 3, **dadurch gekennzeichnet, dass** jedes der Stromversorgungsnetzwerke (20) einen durch Querschnittsveränderung abgleichbaren Widerstand (110, 136) aufweist.

5. Laserstrahlungsquelle nach Anspruch 3 oder 4, **dadurch gekennzeichnet, dass** jedes der Stromversorgungsnetzwerke (20) einen mit der jeweiligen Slave-Laserdiode (12) in Reihe geschalteten abgleichbaren Widerstand (110, 136) aufweist.

6. Laserstrahlungsquelle nach einem der voranstehenden Ansprüche, **dadurch gekennzeichnet, dass** alle Stromversorgungsnetzwerke (20) durch eine gemeinsame Spannungsquelle (22) gespeist sind.

7. Laserstrahlungsquelle nach einem der voranstehenden Ansprüche, **dadurch gekennzeichnet, dass** die Slave-Stromversorgung (18) unabhängig von der Master-Stromversorgung (32) arbeitet.

8. Laserstrahlungsquelle nach einem der voranstehenden Ansprüche, **dadurch gekennzeichnet, dass** die Master-Stromversorgung (32) durch Trimmung abgleichbar ist.

9. Laserstrahlungsquelle nach einem der voranstehenden Ansprüche, **dadurch gekennzeichnet, dass** die Master-Stromversorgung (32) hinsichtlich des Stroms durch die Master-Laserdtode (30) steuerbar ist.

10. Laserstrahlungsquelle nach einem der voranstehenden Ansprüche, **dadurch gekennzeichnet, dass** alle Slave-Laserdioden (12) auf einem gemeinsamen Träger (14) angeordnet sind.

11. Laserstrahlungsquelle nach Anspruch 10, **dadurch gekennzeichnet, dass** der gemeinsame Träger für die Slave-Laserdioden (12) ein Substrat (14) ist.

12. Laserstrahlungsquelle nach Anspruch 10 oder 11, **dadurch gekennzeichnet, dass** die Stromversorgung der Slave-Laserdioden (12) durch auf dem Träger (14) verlaufende Leiterbahnen (138, 140) erfolgt.

13. Laserstrahlungsquelle nach einem der Ansprüche 10 bis 12, **dadurch gekennzeichnet, dass** die Stromversorgungsnetzwerke (20, 136) auf dem Träger (14) angeordnet sind.

14. Laserstrahlungsquelle nach Anspruch 13, **dadurch gekennzeichnet, dass** jeder Slave-Laserdiode (12) ein auf dem Träger (14) im Bereich derselben angeordnetes Stromversorgungsnetzwerk (136) zugeordnet ist.

15. Laserstrahlungsquelle nach Anspruch 14, **dadurch gekennzeichnet, dass** das Stromversorgungsnetzwerk (20) auf dem Träger (14) angeordnete, hinsichtlich seines Widerstands abgleichbare Leiterabschnitte (136) aufweist.

16. Laserstrahlungsquelle nach Anspruch 15, **dadurch gekennzeichnet, dass** die Leiterabschnitte (136) durch Variation eines Querschnitts derselben abgleichbar sind.

17. Laserstrahlungsquelle nach einem der voranstehenden Ansprüche, **dadurch gekennzeichnet, dass** jedes der Stromversorgungsnetzwerke (20) durch Lasertrimmen abgleichbar ist.

18. Laserstrahlungsquelle nach einem der voranstehenden Ansprüche, **dadurch gekennzeichnet, dass** jede der Slave-Laserdioden (12) hinsichtlich ihres Arbeitsbereichs als Slave-Laserdiode so ausgebildet ist, dass durch Einstellung des Stroms eine Resonatorfrequenz (152) der Slave-Laserdiode einstellbar ist.

19. Laserstrahlungsquelle nach einem der voranstehenden Ansprüche, **dadurch gekennzeichnet, dass** eine Phasenlage der Slave-Laserstrahlung (62) jeder Slave-Laserdiode (12) relativ zur Master-Laserstrahlung (34) durch Einstellung des Stroms einstellbar ist.

**20.** Laserstrahlungsquelle nach einem der Ansprüche 10 bis 19, **dadurch gekennzeichnet, dass** die Slave-Laserdioden (12) in einer zweidimensionalen Anordnung (10) angeordnet sind.

**21.** Laserstrahlungsquelle nach Anspruch 20, **dadurch gekennzeichnet, dass** die zweidimensionale Anordnung (10) in jeder ihrer zwei Dimensionen eine Erstreckung von ungefähr derselben Größenordnung aufweist.

**22.** Laserstrahlungsquelle nach einem der Ansprüche 10 bis 21, **dadurch gekennzeichnet, dass** die Slave-Laserdioden (12) und die Master-Laserdiode (30) auf demselben Träger (14) sitzen.

**23.** Laserstrahlungsquelle nach einem der Ansprüche 10 bis 22, **dadurch gekennzeichnet, dass** die Slave-Laserdioden (12) und die Master-Laserdiode (30) auf demselben Substrat (14) sitzen.

**24.** Laserstrahlungsquelle nach Anspruch 22 oder 23, **dadurch gekennzeichnet, dass** eine der Laserdioden einer zusammenhängenden Anordnung (10) die Master-Laserdiode (30) darstellt und die anderen Laserdioden als Slave-Laserdioden (12) arbeiten.

**25.** Laserstrahlungsquelle nach einem der Ansprüche 10 bis 24, **dadurch gekennzeichnet, dass** die Laserdioden (12, 30) als Vertikalemitter (120) auf einem einzigen zusammenhängenden Substrat (14) angeordnet sind.

**26.** Laserstrahlungsquelle nach einem der voranstehenden Ansprüche, **dadurch gekennzeichnet, dass** die Transformationsoptik (60) ein Mikrolinsenarray umfasst.

**27.** Laserstrahlungsquelle nach einem der voranstehenden Ansprüche, **dadurch gekennzeichnet, dass** die Transformationsoptik (60) eine Phasenplatte (72) aufweist, welche die Phase der Slave-Laserstrahlung (62) derart ändert, dass in einer weiteren Ebene (70) eine definierte Intensitätsverteilung entsteht und dass die Transformationsoptik (60) In der weiteren Ebene (70) eine auf die erste Phasenplatte (72) abgestimmte Phasenkorrekturplatte (76) umfasst, welche in dem austretenden Gesamtlaserstrahlungsfeld (64) zu einer definierten Wellenfront (66) führt.

**28.** Laserstrahlungsquelle nach einem der voranstehenden Ansprüche, **dadurch gekennzeichnet, dass** die Transformationsoptik (60) eine Phasenplatte (72) aufweist, welche jeder Slave-Laserstrahlung (62) einer Slave-Laserdiode (12) eine andere Phase gibt und dass die Transformationsoptik (60) eine Fourieroptik (68) umfasst, in deren Fourierebene (70) eine auf die erste Phasenplatte (72) abgestimmte Phasenkorrekturplatte (76) angeordnet ist, welche in dem austretenden Gesamtlaserstrahlungsfeld (64) zu einer ebenen Wellenfront (66) führt.

**29.** Laserstrahlungsquelle nach Anspruch 27 oder 28, **dadurch gekennzeichnet, dass** die Phasenplatte (72) eine durch einen Algorithmus festgelegte Phasenverschiebung zwischen der Slave-Laserstrahlung (62) verschiedener Slave-Laserdioden (12) bewirkt.

**30.** Laserstrahlungsquelle nach Anspruch 29, **dadurch gekennzeichnet, dass** die Phasenplatte (72) eine ausgehend von einem Mittelpunkt (12M) nach allen Richtungen in gleicher Weise variierende Phasenlage bewirkt.

**31.** Laserstrahlungsquelle nach Anspruch 30, **dadurch gekennzeichnet, dass** die Variation der Phasenlage entsprechend einer monoton verlaufenden analytischen Funktion erfolgt.

**32.** Laserstrahlungsquelle nach einem der voranstehenden Ansprüche, **dadurch gekennzeichnet, dass** durch die Kopplungsoptik (36) die Master-Laserstrahlung (34) über die Transformationsoptik (60) in die Slave-Laserdioden (12) einkoppelbar ist.

**33.** Laserstrahlungsquelle nach Anspruch 32, **dadurch gekennzeichnet, dass** die Master-Laserstrahlung (34) die Phasenkorrekturplatte (76) und die Phasenplatte (72) durchsetzt.

**34.** Laserstrahlungsquelle nach einem der voranstehenden Ansprüche, **dadurch gekennzeichnet, dass** die Transformationsoptik (60) in einen zusammenhängenden Block (100, 100') integriert ist.

**35.** Laserstrahlungsquelle nach Anspruch 34, **dadurch gekennzeichnet, dass** optische Elemente (60, 36) der Transformationsoptik (100) als Elemente der diffraktiven Optik ausgebildet sind.

**36.** Laserstrahlungsquelle nach Anspruch 34 oder 35, **dadurch gekennzeichnet, dass** die Kopplungsoptik (36) in den Block (100, 100') integriert ist.

**Claims**

**1.** Laser radiation source comprising an array of N individual slave laser diodes (12) in a predetermined surface area, a slave power supply (18) for the slave laser diodes (12), a master laser diode (30) for generating a master laser radiation (34), a master power supply (32) for the master laser diode (30), an optical coupling device (36) for coupling the master laser radiation (34) into the individual slave laser diodes (12) in order to operate them at the frequency of the master laser diode (30) in a phase-locked manner, and an optical transformation device (60) combining the slave laser radiation (62) of the individual slave laser diodes (12) to form a coherent total laser radiation field (64) with essentially plane wave fronts (66), **characterized in that** the slave power supply (18) has a separate power supply network (20) for each slave laser diode (12), **in that** each of the power supply networks (20) is adjustable with respect to the current supplied to the respective slave laser diode (12) during a certain operating period for adjusting the slave laser diodes (12) relative to one another, **in that** the power supply networks (20) are connected in parallel and are supplied by a common source (22), and **in that** the optical coupling device (36) comprises a decoupling element (46), by means of which the master laser radiation (34) is coupled into the slave laser diodes (12), and through which the total laser radiation field (64) passes without any outcoupling.

2. Laser radiation source in accordance with claim 1, **characterized in that** each of the power supply networks (20) is adjustable one time by trimming.

3. Laser radiation source in accordance with claim 1 or 2, **characterized in that** each of the power supply networks (20) is a resistance network.

4. Laser radiation source in accordance with claim 3, **characterized in that** each of the power supply networks (20) has a resistor (110, 136) adjustable by alteration of the cross section.

5. Laser radiation source in accordance with claim 3 or 4, **characterized in that** each of the power supply networks (20) has an adjustable resistor (110, 136) connected in series with the respective slave laser diode (12).

6. Laser radiation source in accordance with any one of the preceding claims, **characterized in that** all the power supply networks (20) are supplied by a common voltage source (22).

7. Laser radiation source in accordance with any one of the preceding claims, **characterized in that** the slave power supply (18) operates independently of the master power supply (32).

8. Laser radiation source in accordance with any one of the preceding claims, **characterized in that** the master power supply (32) is adjustable by trimming.

9. Laser radiation source in accordance with any one of the preceding claims, **characterized in that** the master power supply (32) is controllable with respect to the current through the master laser diode (30).

10. Laser radiation source in accordance with any one of the preceding claims, **characterized in that** all the slave laser diodes (12) are arranged on a common support (14).

11. Laser radiation source in accordance with claim 10, **characterized in that** the common support for the slave laser diodes (12) is a substrate (14).

12. Laser radiation source in accordance with claim 10 or 11, **characterized in that** the power supply of the slave laser diodes (12) is brought about by way of path conductors (138, 140) extending on the support (14).

13. Laser radiation source in accordance with any one of claims 10 to 12, **characterized in that** the power supply networks (20, 136) are arranged on the support (14).

14. Laser radiation source in accordance with claim 13, **characterized in that** there is associated with each slave laser diode (12) a power supply network (136) which is arranged on the support (14) in the area of the slave laser diode.

15. Laser radiation source in accordance with claim 14, **characterized in that** the power supply network (20) has conductor sections (136) arranged on the support (14) and adjustable with respect to its resistance.

16. Laser radiation source in accordance with claim 15, **characterized in that** the conductor sections (136) are adjustable by way of variation of a cross section thereof.

17. Laser radiation source in accordance with any one of the preceding claims, **characterized in that** each of the power supply networks (20) is adjustable by way of laser trimming.

18. Laser radiation source in accordance with any one of the preceding claims, **characterized in that** each of the slave laser diodes (12) is designed with respect to its operating range as a slave laser diode such that a resonator frequency (152) of the slave laser diode is adjustable via current adjustment.

19. Laser radiation source in accordance with any one of the preceding claims, **characterized in that** a phase relationship of the slave laser radiation (62) of each slave laser diode (12) relative to the master laser radiation (34) is adjustable via current adjustment.

20. Laser radiation source in accordance with any one of claims 10 to 19, **characterized in that** the slave laser diodes (12) are arranged in a two-dimensional array (10).

21. Laser radiation source in accordance with claim 20, **characterized in that** the two-dimensional array (10) has in each of its two dimensions an extent of approximately the same order of magnitude.

22. Laser radiation source in accordance with any one of claims 10 to 21, **characterized in that** the slave laser diodes (12) and the master laser diode (30) are seated on the same support (14).

23. Laser radiation source in accordance with any one of claims 10 to 22, **characterized in that** the slave laser diodes (12) and the master laser diode (30) are seated on the same substrate (14).

24. Laser radiation source in accordance with claim 22 or 23, **characterized in that** one of the laser diodes of a continuous array (10) represents the master laser diode (30) and the other laser diodes operate as slave laser diodes (12).

25. Laser radiation source in accordance with any one of claims 10 to 24, **characterized in that** the laser diodes (12, 30) are arranged on a single, continuous substrate (14) as vertical emitters (120).

26. Laser radiation source in accordance with any one of the preceding claims, **characterized in that** the optical transformation device (60) comprises a microlens array.

27. Laser radiation source in accordance with any one of the preceding claims, **characterized in that** the optical transformation device (60) has a phase plate (72) altering the phase of the slave laser radiation (62) in such a manner that a defined distribution of intensity results in a further plane (70), and **in that** the optical transformation device (60) comprises in the further plane (70) a phase corrector plate (76) adjusted to the first phase plate (72) and leading to a defined wave front (66) in the exiting total laser radiation field (64).

28. Laser radiation source in accordance with any one of the preceding claims, **characterized in that** the optical transformation device (60) has a phase plate (72) giving each slave laser radiation (62) of a slave laser diode (12) a different phase, and **in that** the optical transformation device (60) comprises a Fourier optical device (68), in the Fourier plane (70) of which there is arranged a phase corrector plate (76) which is adjusted to the first phase plate (72) and leads to a plane wave front (66) in the exiting total laser radiation field (64).

29. Laser radiation source in accordance with claim 27 or 28, **characterized in that** the phase plate (72) effects a phase shift determined by an algorithm between the slave laser radiation (62) of different slave laser diodes (12).

30. Laser radiation source in accordance with claim 29, **characterized in that** the phase plate (72) effects a phase relationship proceeding from a center point (12M) and varying in the same manner in all directions.

31. Laser radiation source in accordance with claim 30, **characterized in that** the variation in the phase relationship is brought about in accordance with a monotonic analytical function.

32. Laser radiation source in accordance with any one of the preceding claims, **characterized in that** the master laser radiation (34) can be coupled into the slave laser diodes (12) via the optical transformation device (60) by the optical coupling device (36).

33. Laser radiation source in accordance with claim 32, **characterized in that** the master laser radiation (34) passes through the phase corrector plate (76) and the phase plate (72).

34. Laser radiation source in accordance with any one of the preceding claims, **characterized in that** the optical transformation device (60) is integrated into a coherent block (100, 100').

35. Laser radiation source in accordance with claim 34, **characterized in that** optical elements (60, 36) of the optical transformation device (100) are configured as elements of diffractive optics.

36. Laser radiation source in accordance with claim 34 or 35, **characterized in that** the optical coupling , device (36) is integrated into the block (100, 100').

**Revendications**

1. Source de rayonnement laser comprenant un agencement de N diodes laser esclaves individuelles (12) dans une surface prédéterminée, une alimentation électrique esclave (18) pour les diodes laser esclaves (12), une diode laser maître (30) pour la production d'un rayonnement laser maître (34), une alimentation électrique maître (32) pour la diode laser maître (30), une optique de couplage (36), avec laquelle le rayonnement laser maître (34) peut être couplé dans les diodes laser esclaves individuelles (12), afin de commander celles-ci à phase bloquée à la fréquence de la diode laser maître (30), et une optique de transformation (60), qui réunit le rayonnement laser esclave (62) des diodes laser esclaves individuelles (12) en un champ de rayonnement laser global cohérent (64) avec des fronts d'onde essentiellement plans (66), **caractérisée en ce que** l'alimentation électrique esclave (18) présente un réseau d'alimentation électrique propre (20) pour chaque diode laser esclave (12), **en ce que** chacun des réseaux d'alimentation électrique (20) peut être équilibré en ce qui concerne le courant fourni à la diode laser esclave respective (12) pendant une période de temps déterminée pour accorder les diodes laser esclaves (12) l'une par rapport à l'autre, **en ce que** les réseaux d'alimentation électrique (20) sont montés en parallèle et sont alimentés par une source commune (22), et **en ce que** l'optique de couplage (36) présente un élément de découplage (46), par lequel le rayonnement laser maître (34) est couplé dans les diodes laser esclaves (12) et qui traverse sans découplage le champ de rayonnement laser global (64).

2. Source de rayonnement laser selon la revendication 1, **caractérisée en ce que** chacun des réseaux d'alimentation électrique (20) peut être équilibré une seule fois par ajustage.

3. Source de rayonnement laser selon la revendication 1 ou 2, **caractérisée en ce que** chacun des réseaux d'alimentation électrique (20) est un réseau de résistances.

4. Source de rayonnement laser selon la revendication 3, **caractérisée en ce que** chacun des réseaux d'alimentation électrique (20) présente une résistance (110, 136) pouvant être équilibrée par variation de la section transversale.

5. Source de rayonnement laser selon la revendication 3 ou 4, **caractérisée en ce que** chacun des réseaux d'alimentation électrique (20) présente une résistance pouvant être équilibrée (110, 136) montée en série avec la diode laser esclave respective (12).

6. Source de rayonnement laser selon l'une quelconque des revendications précédentes, **caractérisée en ce que** tous les réseaux d'alimentation électrique (20) sont alimentés par une source de tension commune (22).

7. Source de rayonnement laser selon l'une quelconque des revendications précédentes, **caractérisée en ce que** l'alimentation électrique esclave (18) opère indépendamment de l'alimentation électrique maître (32).

8. Source de rayonnement laser selon l'une quelconque des revendications précédentes, **caractérisée en ce que** l'alimentation électrique maître (32) peut être équilibrée par ajustage.

9. Source de rayonnement laser selon l'une quelconque des revendications précédentes, **caractérisée en ce que** l'alimentation électrique maître (32) peut être commandée au niveau du courant au moyen de la diode laser maître (30).

10. Source de rayonnement laser selon l'une quelconque des revendications précédentes, **caractérisée en ce que** toutes les diodes laser esclaves (12) sont disposées sur un support commun (14).

11. Source de rayonnement laser selon la revendication 10, **caractérisée en ce que** le support commun pour les diodes laser esclaves (12) est un substrat (14).

12. Source de rayonnement laser selon la revendication 10 ou 11, **caractérisée en ce que** l'alimentation électrique des diodes laser esclaves (12) est effectuée au moyen de voies conductrices (138, 140) formées sur le support (14).

13. Source de rayonnement laser selon l'une quelconque des revendications 10 à 12, **caractérisée en ce que** les réseaux d'alimentation électrique (20, 136) sont disposés sur le support (14).

14. Source de rayonnement laser selon la revendication 13, **caractérisée en ce qu'**à chaque diode laser esclave (12) est associé un réseau d'alimentation électrique (136) disposé sur le support (14) dans la région de celle-ci.

15. Source de rayonnement laser selon la revendication 14, **caractérisée en ce que** le réseau d'alimentation électrique (20) présente des segments de conducteur (136) pouvant être équilibrés au niveau de leur résistance et disposés sur le support (14).

16. Source de rayonnement laser selon la revendication 15, **caractérisée en ce que** les segments de conducteur (136) peuvent être équilibrés par variation d'une section transversale de ceux-ci.

17. Source de rayonnement laser selon l'une quelconque des revendications précédentes, **caractérisée en ce que** chacun des réseaux d'alimentation électrique (20) peut être équilibré par ajustage du laser.

18. Source de rayonnement laser selon l'une quelconque des revendications précédentes, **caractérisée en ce que** chacune des diodes laser esclaves (12) est réalisée au niveau de son domaine de travail sous la forme d'une diode laser esclave, de telle manière qu'une fréquence de résonateur (152) de la diode laser esclave puisse être réglée par réglage du courant.

19. Source de rayonnement laser selon l'une quelconque des revendications précédentes, **caractérisée en ce qu'**une position de phase du rayonnement laser esclave (62) de chaque diode laser esclave (12) par rapport au rayonnement laser maître (34) est réglable par réglage du courant.

20. Source de rayonnement laser selon l'une quelconque des revendications 10 à 19, **caractérisée en ce que** les diodes laser esclaves (12) sont disposées en un agencement bidimensionnel (10).

21. Source de rayonnement laser selon la revendication 20, **caractérisée en ce que** l'agencement bidimensionnel (10) présente dans chacune de ses deux dimensions une extension présentant environ le même ordre de grandeur.

22. Source de rayonnement laser selon l'une quelconque des revendications 10 à 21, **caractérisée en ce que** les diodes laser esclaves (12) et la diode laser maître (30) sont placées sur le même support (14).

23. Source de rayonnement laser selon l'une quelconque des revendications 10 à 22, **caractérisée en ce que** les diodes laser esclaves (12) et la diode laser maître (30) sont placées sur le même substrat (14).

24. Source de rayonnement laser selon la revendication 22 ou 23, **caractérisée en ce qu'**une des diodes laser d'un agencement continu (10) représente la diode laser maître (30) et les autres diodes laser opèrent comme diodes laser esclaves (12).

25. Source de rayonnement laser selon l'une quelconque des revendications 10 à 24, **caractérisée en ce que** les diodes laser (12, 30) sont disposées sous forme d'émetteurs verticaux (120) sur un substrat continu unique (14).

26. Source de rayonnement laser selon l'une quelconque des revendications précédentes, **caractérisée en ce que** l'optique de transformation (60) comprend un réseau de microlentilles.

27. Source de rayonnement laser selon l'une quelconque des revendications précédentes, **caractérisée en ce que** l'optique de transformation (60) présente une lame de phase (72), qui modifie la phase du rayonnement laser esclave (62) de telle manière qu'il apparaisse dans un autre plan (70) une répartition d'intensité définie et **en ce que** l'optique de transformation (60) comprend dans l'autre plan (70) une lame de correction de phase (76) accordée avec la première lame de phase (72), qui conduit à un front d'onde défini (66) dans le champ de rayonnement laser global sortant (64).

28. Source de rayonnement laser selon l'une quelconque des revendications précédentes, **caractérisée en ce que** l'optique de transformation (60) présente une lame de phase (72), qui confère une autre phase à chaque rayonnement laser esclave (62) d'une diode laser esclave (12) et **en ce que** l'optique de transformation (60) comprend une optique de Fourier (68), dans le plan de Fourier (70) de laquelle est disposée une lame de correction de phase (76) accordée avec la première lame de phase (72), qui conduit à un front d'onde plan (66) dans le champ de rayonnement laser global sortant (64).

29. Source de rayonnement laser selon la revendication 27 ou 28, **caractérisée en ce que** la lame de phase (72) provoque un déphasage défini par un algorithme entre le rayonnement laser esclave (62) de différentes diodes laser esclaves (12).

30. Source de rayonnement laser selon la revendication 29, **caractérisée en ce que** la lame de phase (72) provoque une position de phase variant de la même manière dans toutes les directions à partir d'un point central (12M).

31. Source de rayonnement laser selon la revendication 30, **caractérisée en ce que** la variation de la position de phase est effectuée suivant une fonction analytique d'allure monotone.

32. Source de rayonnement laser selon l'une quelconque des revendications précédentes, **caractérisée en ce que** le rayonnement laser maître (34) peut être couplé dans les diodes laser esclaves (12) par l'optique de transformation (60) au moyen de l'optique de couplage (36).

33. Source de rayonnement laser selon la revendication 32, **caractérisée en ce que** le rayonnement laser maître (34) traverse la lame de correction de phase (76) et la lame de phase (72).

34. Source de rayonnement laser selon l'une quelconque des revendications précédentes, **caractérisée en ce que** l'optique de transformation (60) est intégrée dans un bloc continu (100, 100').

35. Source de rayonnement laser selon la revendication 34, **caractérisée en ce que** des éléments optiques (60, 36) de l'optique de transformation (100) sont réalisés sous la forme d'éléments de l'optique de diffraction.

**36.** Source de rayonnement laser selon la revendication 34 ou 35, **caractérisée en ce que** l'optique de couplage (36) est intégrée dans le bloc (100, 100').

EP 1 151 344 B1

FIG.1

FIG.2        FIG.3        FIG.4        FIG.5

FIG.6

FIG.7  FIG.8  FIG.9  FIG.10

EP 1 151 344 B1

FIG.11

FIG.12

FIG.13

# FIG.14

EP 1 151 344 B1

FIG.15

136c

136d

136 b
132
130

136a
126

140

138

FIG.16

136d'    144    143    144

136d'$_1$    142    136d'$_2$

FIG.17

144 k

136d'$_1$    143    142    143    136d'$_2$

FIG.18

Locking Range

Leistungs -
dichte

154

152

34'

62

34

ν

ν

FIG.19

ΔΦ $\frac{\pi}{2}$

relative
Phase
zwischen
Master und
Slave

ν

$-\frac{\pi}{2}$

FIG.20

64

100'

62₁

62₂

102'

162

160

168

164

121

10

FIG.21

Phasenfunktion ( Schnitt )

$12_1$   $12_M$   $12_{11}$

FIG.22

Höhenfunktion ( Schnitt )

$12_1$   $12_M$   $12_{11}$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **Lars Bartelt-Berger et al.** *Applied Optics,* 20. September 1999, vol. 38 (27), 5752-5760

- **P. EHBETS ; H.P. HERZIG ; R. DÄNDLIKER ; P. REGNAULT ; I. KJELBERG.** Beam shaping of high-power laser diode arrays by continuous surface-relief elements. *Journal of Modern Optics,* 1993, vol. 40 (4), 637-645